(19) **Europäisches Patentamt**

**European Patent Office**

**Office européen des brevets**

(11) **EP 1 223 432 B1**

(12) **EUROPEAN PATENT SPECIFICATION**

(45) Date of publication and mention
of the grant of the patent:
**23.03.2005 Bulletin 2005/12**

(51) Int Cl.⁷: **G01R 31/28**, H04B 17/00,
H04Q 7/34, G01R 29/10

(21) Application number: **01610005.9**

(22) Date of filing: **16.01.2001**

(54) **A chamber for and a method of processing electronic devices and the use of such a chamber**

Kammer und Verfahren zur Bearbeitung elektronischer Geräte und deren Anwendung

Chambre et procédé pour le traitement des appareils électriques, et l'utilisation d'une telle chambre

(84) Designated Contracting States:
**AT BE CH CY DE DK ES FI FR GB GR IE IT LI LU
MC NL PT SE TR**

(43) Date of publication of application:
**17.07.2002 Bulletin 2002/29**

(73) Proprietor: **Telefonaktiebolaget LM Ericsson
(publ)
164 83 Stockholm (SE)**

(72) Inventors:
• **Persson, Anders
582 25 Linköping (SE)**
• **Madsen, Kent
589 21 Linköbing (SE)**

• **Bergstedt, Hans
584 31 Linköbing (SE)**

(74) Representative: **Vigars, Christopher Ian et al
HASELTINE LAKE,
Redcliff Quay,
120 Redcliff Street
Bristol BS1 6HU (GB)**

(56) References cited:
**EP-A- 0 848 260          DE-A- 4 105 440
DE-A- 19 747 399       DE-A- 19 812 923
US-A- 5 397 988         US-A- 5 805 667
US-A- 6 021 315**

## Description

### Technical Field of the Invention:

The present invention relates to the production and test of electronic devices.

The invention relates specifically to: A chamber for processing electronic devices.

The invention furthermore relates to: A method of processing electronic devices.

The invention furthermore relates to: The use of a chamber for processing electronic devices.

### Description of Related Art:

The following account of the prior art relates to one of the areas of application of the present invention, test of mobile telephones.

The production of electronic devices such as mobile telephones in large volumes brings focus on all aspects of the development and production process in order to improve quality, decrease processing times and reduce costs to follow the pace of the market.

One aspect of this is the testing of devices. To ensure constant quality, devices must be individually tested and preferably under different environmental conditions. This is a time-consuming task, however.

It is important to reduce the time and cost of the test in the production. Testing mobile phones in different environmental conditions is important to verify the design and control the manufacturing process.

The publication "Measurement of terminal antennas performance in multimode reverberation chambers", Conference Proceedings from 'Antenn 00' conference in Lund, September 11-14, 2000, p. 159-164, deals with the characterization of small antennas in a multi-path environment (e.g. antennas for mobile phones or Bluetooth modules). The test is carried out on an individual basis, e.g. in a reverberation chamber. Measurements of radiation efficiency of antennas in the 900 and 1800 MHz bands are reported.

EP-A-848 260 (Rohde & Schwarz), 17.06.1998, discloses goods carriers that are transported along a conveyor and through an adaptor station which is the equivalent of a chamber. Each goods carrier carries a small number of mobile phones, each of which is connected by wires to a control computer on the goods carrier. It is the control computer on each. goods carrier that communicates with the measuring (testing) system.

US-A-5 805 667 (Alvarez et al.), Sep. 8, 1998, concerns the testing of cordless telephones and their respective bases simultaneously in an anechoic chamber. The method of testing concerns connecting the two portions using wires. The test chamber is an absorbing chamber.

US-A-6 021 315 (Telewski), Feb. 1, 2000, discloses a method of testing electronic devices, one at a time, by passing the devices through a waveguide.

### Summary:

The problem of the prior art is that the testing of the electronic devices is done one at a time in a test fixture. The openings and closings of the door of the test cell are done for every device. This increases testing time and the wear of the EMC gaskets, etc. In some cases, test fixtures specific for each type of device under test must be designed for every new device type. It is complicated (time-consuming and thus expensive) to make environmental tests at the same time as testing other properties, e.g. testing radiated power from an antenna of a mobile telephone at extreme temperatures because each device must be temperature cycled individually.

The object of the present invention is to provide a flexible system for and method of decreasing the processing time per unit of electronic devices during production and test, thus reducing costs.

This is achieved according to the invention in that the chamber is adapted for handling several devices simultaneously and said processing comprises a transfer of airborne signals.

In the present context, the term 'simultaneously' is taken to mean 'while located in the chamber'. In other words it may mean 'at the same time' or 'synchronously' or 'sequentially' or 'asynchronously', etc.

In the present context, the term 'electronic devices' includes portable radio communications devices, i.e. mobile radio terminals (including cellular telephones, DECT telephones (DECT = Digital European Cordless Telecommunications), pagers, communicators such as electronic organizers, smart phones, Personal Digital Assistants, etc.) and other electronic devices having a wireless interface, e.g. a radio interface (including consumer electronic devices having a wireless interface, e.g. a Bluetooth interface, e.g. headsets, computers, key boards, etc.), and optionally an acoustic interface (e.g. a mobile telephone, a PC, etc.) and optionally an optical interface (e.g. a mobile telephone, a remote control using infra red light, etc.).

It should be emphasized that the term "comprises/comprising" when used in this specification is taken to specify the presence of stated features, integers, steps or components but does not preclude the presence or addition of one or more other features, integers, steps, components or groups thereof.

According to one aspect of the present invention there is provided a method of handling a plurality of electronic devices simultaneously in a mode-stirred chamber, the method comprising: positioning a plurality of electronic devices within the chamber; transmitting radio frequency signals directly to the plurality of electronic devices from a transmitting antenna of the chamber, processing the electronic devices within the chamber, receiving airborne signals directly from the plurality of electronic devices at a receiver of the chamber, the received airborne signals relating to processing results of the plurality of electronic devices; and removing the plurality of electronic devices from the chamber.

According to another aspect of the present invention there is provided a mode-stirred chamber for handling a plurality of electronic devices simultaneously, comprising:

means for positioning a plurality of electronic devices in the chamber; a transmit antenna; a base station operable to transmit radio frequency signals directly to electronic devices positioned within the chamber via the transmit antenna; a receiver for receiving airborne signals directly from the plurality of electronic devices, the airborne signals relating to processing results of the electronic devices; and means for removing the plurality of electronic devices from the chamber.

An advantage of the invention is that many devices are tested simultaneously (decreases testing time per unit, reduces wear of the test chamber). The chamber may e.g. be used for production test of high volume devices.

When said chamber is a climatic chamber, it is ensured that the processing may be performed at different climatic conditions, e.g. according to a specification to comply with a specific standard or quality requirements. Environmental parameters such as temperature, humidity, pressure, atmosphere (air, specific gases or fluids, specific pH, etc.) may be varied. An example of the use of the invention is in connection with the testing of radio properties of devices over temperature, in which case e.g. performing temperature cycling on many devices simultaneously is of great advantage by saving time.

When said chamber is electromagnetically shielded, it is ensured that the processes carried out in the chamber are not disturbed by electromagnetic noise from the environment, which increases the reliability of measurements in the chamber. Further, it prevents possible electromagnetic noise from the activities in the chamber from reaching the environment.

When said chamber is anechoic, it is ensured that reflections from the walls of the chamber are minimized, which is of importance to some acoustic and electromagnetic measurements.

When said chamber is echoic, it is ensured that reflections from the wall create a multi-path environment in the chamber, thus contributing to the homogeneity of the acoustic or electromagnetic field distribution in the chamber.

When said chamber comprises at least one mode stirrer, it is ensured that the acoustic or electromagnetic field distribution becomes randomised, approximating a homogeneous and isotropic field distribution inside the chamber, creating a so-called mode-stirred chamber (MSC) or reverberation chamber. In other words, the field strength is approximately "the same" in all points of the chamber and independent of direction. This has e.g. obvious advantages in the case of a mode-stirred chamber for measuring radio properties of mobile communications devices by removing the need for the development of special test fixtures for each different type of device (because the orientation of the devices becomes less significant), reducing costs. Further, the measurements are relatively independent of the location of the devices and of the direction of the antennas, making the chamber well suited for handling several devices simultaneously under approximately identical field conditions. The mode-stirred chamber has been extensively used in connection with measurements concerning electromagnetic compatibility (EMC), and its properties are well understood.

A mode-stirred chamber is similar to a microwave oven, i.e. it is a cavity with a (possibly metallic) paddle which stirs the modes of the chamber in a statistical way so that the net result will be that the equipment under test will be illuminated by waves from all directions and all polarizations, when the paddle has been revolved in steps around the axis. There are two major advantages of a mode-stirred chamber, compared with other test methods (such as open area test and anechoic chamber): Firstly in immunity testing it is possible to get many volts per meter per watt input power, since the chamber acts like a resonant cavity. Secondly, both in immunity and emissions testing, the measurement method very rapidly gives the average value for each frequency of the immunity and emissions over all angles of incidence. The function of the stirring paddle is to create different boundary conditions at every paddle position, so that each paddle position creates a new field distribution, which is uncorrelated to every other paddle position. In order to achieve this, the stirrer must be electrically large and have sufficient asymmetry in relation to the wavelength. The field inside a properly designed mode-stirred chamber is isotropic; i.e. the field strength in average over all stirrer positions is the same in every position of the mode-stirred chamber. The stirring ratio is also used as a property as to how well the stirrer can change the field strength at a point, from minimum to the maximum field strength. For a good stirring efficiency, it is required that the stirring ratio should be at least 20 dB.

The mode-stirred chamber should be electrically large in physical size; i.e. it is the lowest frequency to be measured which determines the minimum size of the chamber. Experience shows that a number of wavelengths should fit in size of the chamber. The construction of a mode-stirred chamber is in most cases realized as a rectangular cavity with the wall dimensions a, b and d.

The different eigenmodes in the mode-stirred chamber can be calculated with the formula:

$$f_{ijk} = \frac{c_0}{2} \cdot \sqrt{\left(\frac{i}{a}\right)^2 + \left(\frac{j}{b}\right)^2 + \left(\frac{k}{d}\right)^2}$$

Equation 1

Where a, b and d are the dimensions of the chamber and $c_0$ is the speed of light. For a chamber with dimensions (5.100 * 2.457 * 3.000) $m^3$, the lowest order mode is $f_{101}$. From these size measures a lowest frequency mode of 58.01 MHz is derived. The lowest mode is a physical limit to how low frequencies can exist in a rectangular cavity, but in order to be a useful mode-stirred chamber, the lower limit of operation is in practice at least a factor of 5-6 higher. In practice we are interested in a mode-stirred chamber with a sufficiently large number of eigenmodes per Hz. The eigenmode density is a function of both the frequency f of the driving source as well as the dimensions of the cavity a, b and d.

An advantage of using a mode-stirred chamber is that it is possible to estimate measurement uncertainty by statistical methods.

When said chamber is adapted for testing said electronic devices, it is ensured that parallel tests of devices under controlled conditions is possible, potentially reducing testing time, and that all relevant parameters for the electronic devices in question can be tested in the same chamber.

When said chamber is adapted for downloading of software to said electronic devices, it is ensured that a parallel handling of the loading of essential 'components' of the devices at various stages of the development, production and test process is possible. The valuable software is kept in a shielded environment, i.e. no disturbances due to EMC noise from the environment are present and no electromagnetic 'pollution' of the environment is generated during downloading. Further, and economically importantly, no undesired tapping of the information is possible during the downloading process.

When said chamber is adapted for testing radio communications devices according to a predetermined test program in that said chamber comprises a base station for setting up calls to a group of the radio communications devices in the chamber, each device being assigned a unique receive and transmit channel, said devices comprising basic software and energizing means at least enabling the completion of the test, and at least one receive antenna for receiving radio signals from said group, it is ensured that automatic testing can be performed. The use of automatic testing ensures increased reliability and a reduction of test time. Further, measurements may be performed at different frequencies simultaneously. Different tests may likewise be performed on individual devices simultaneously. The energizing means could e.g. be a battery or photovoltaic cell, etc. or the sufficient amount of energy could be transferred to the device via an air interface. The important issue is that the device under test has sufficient energy for the relevant test to be carried out. Likewise, the term 'basic software' is taken to mean the software that is necessary for the relevant test to be carried out.

When said chamber comprises a transmit antenna for a separate air interface, and each of said radio communications devices comprises a receive module for said separate air interface, and at least a part of said basic software is downloaded to the devices in said chamber via said separate air interface, it is ensured that the devices may be ready for entering the test chamber even if they do not contain the necessary software. In many cases such a separate channel is already present for peripheral interfaces, i.e. it may not be necessary to introduce an extra channel for this purpose.

When at least a part of said predetermined test program is downloaded to the radio communications devices in said chamber via said separate air interface, it is ensured that the test program for the devices may be conveniently transferred to the devices. Further, individual test programs for different devices may be applied (either for different types of devices or for various items of the same type that for some reason need a special test programme (to be used for special purposes, in tropical environments, for special customers, etc.). In many cases such a separate channel is already present for peripheral interfaces, in which case it is not necessary to introduce an extra channel for this purpose.

When said chamber comprises a receive antenna for a separate air interface, and each of said radio communications devices comprises a transmit module for said separate air interface, and at least a part of the results of the completed test program is transferred from the radio communications devices to said receive antenna via said separate air interface, it is ensured that the part of the test results that originate in the device under test may be wirelessly transferred to a processing unit, e.g. a PC connected to the receive antenna via a receiver.

When said separate air interface is based on the Bluetooth standard, it is ensured that a standardized interface is provided, which is attractive for communicating via aerial with peripherals. The separate air interface might, of course, as well be any other appropriate air interface such as IEEE 802.11b, HomeRF, etc.

When said group of the radio communications devices in the chamber comprises all devices in the chamber, it is ensured that the processing time is reduced to a minimum.

When said group of devices is composed in such a way that the distance between adjacent devices is optimised to minimize the influence of mutual coupling on the measurements, it is ensured that a compact configuration of the devices is achieved which still ensures an accurate measurement.

When said chamber is provided with at least one EMC shielding opening element for inserting and removing said devices from the chamber, it is ensured that the electromagnetic energy in the chamber is not allowed to escape via the opening element, i.e. the EMC properties of the chamber are not hampered.

When said chamber is provided with electromagnetic entering and exiting waveguides for inserting and removing said devices in and from the chamber, respectively, said waveguides having cut off frequencies above the highest frequency used for test in the chamber, it is ensured that a continuous test mode is possible, because the entry and exit of devices may be seamlessly performed without hampering the EMC properties of the chamber.

When said chamber has a conveyor consisting of a dielectric support material for supporting said electronic devices, said conveyor enabling a transport of said devices from said entering waveguide to said exiting waveguide, it is ensured that the entry and exit of devices to and from the chamber may be conveniently automated.

When said chamber comprises a separate, smaller inner chamber adapted for keeping the electronic devices in a controlled atmosphere, temperature and humidity, and the walls of said chamber are made of a material that is relatively transparent to electromagnetic waves, it is ensured that time constants for changing the environmental parameters (e.g. temperature) for the devices under test may be kept at a minimum (by keeping the relevant volume for which these parameters must be changed at a minimum), thus saving time, materials and energy.

When said chamber is adapted for testing the average output power of each of said radio communications devices by rotating one of said at least one stirrer, and averaging the results of several measurements for each rotation of said stirrer, it is ensured that a relevant parameter for testing the radio properties of the devices is conveniently provided.

When said chamber is adapted for testing the radiation efficiency of each of said radio communications devices by first making a measurement using a reference antenna against which the efficiency of said radio communication devices is compared, it is ensured that a relevant parameter for testing the radio properties of the devices is conveniently provided.

When said chamber is adapted for testing acoustic and optical properties of said devices, it is ensured that other parameters than those related to the radio properties of the devices may be measured in the same chamber, thus saving testing time. Relevant acoustic tests could e.g. include tests of possible microphone and loudspeaker units, voice interfaces, etc. Relevant optical tests could e.g. include tests of possible display and other optical units, such as infrared transmitters or sensors, photodiodes or sensors, laser diodes, etc.

When said chamber comprises one or more field diffusing elements, it is ensured that a good performance of the mode-stirred chamber also for the lower end of the frequency spectrum is provided. A known method is to use field diffusers in the form of irregular pieces of metal protruding from the wall of the chamber.

When said field diffusing elements comprise cavities located inside the chamber, said cavities being filled by dielectric material with a high dielectric constant and a low loss factor, it is ensured that elements protruding from the walls may be avoided, allowing a smaller chamber to be used. The new dielectrically filled diffusers are larger electrically than physically, and since they do not protrude into the chamber they do not take up any space, thus optimising the usable volume of the chamber. The technique may be used in any mode-stirred chamber.

When said at least one mode stirrer is covered with a dielectric material with a high dielectric constant and a low loss factor, it is ensured that a smaller stirrer and thus a smaller step motor for moving the stirrer may be used and also that the settling time of the stirrer is smaller. The new stirring concept consists of a stirrer covered by a dielectric material with a high epsilon and a low loss factor. The size of the metallic field-stirring tuner is important for the total volume of the chamber, because the stirrer may take up a large fraction of the usable test volume of the chamber. The technique may be used in any mode-stirred chamber.

When said chamber comprises a vibrator for inducing mechanical vibrations, it is ensured that the measurements of radio or acoustic or optical properties may be performed in a vibrating environment simulating the use of the device under such conditions. Further, the mechanical vibration may be used to improve the uniformity of the field distribution, because it acts as an added stirring effect independently of the possible other stirrers and field diffusers of the chamber.

When said chamber is provided with several receiving antennas for each device under test, it is ensured that the measurement accuracy is improved.

When said chamber is provided with one receiving antenna for each device under test, it is ensured that the receiving antenna may be optimised to each type of device, thus facilitating the use of the chamber for many different types of devices and frequency ranges.

When said chamber is adapted for downloading the enabling software to said devices while said devices are individually packaged in their final package, it is ensured that the final, decisive value may be added to the device (and possibly customized depending on the country, customer group, etc.) in connection with the sale or shipment of the devices. Often, electronic devices are only of value when the software is present, i.e. the 'naked' devices are not interesting objects for theft. The software that allows the actual use of the device may be loaded as late as possible in the value chain (e.g. in the shop). Further, the physical devices may be produced and shipped, while the software is still under development, modification or test.

A method of processing electronic devices is furthermore provided by the present invention. When several devices are processed simultaneously in a mode-stirred chamber, and said processing comprises a transfer of airborne signals, the same advantages as mentioned for claim 1 are achieved.

When said processing comprises downloading of software to said electronic devices, the same advantages as mentioned for the corresponding system claim are achieved. The method of downloading software to an electronic device may also be used on a single unit in a mode-stirred chamber, e.g. in connection with a change of software for a particular unit at a customer support centre, or ultimately when the customer buys the phone in the shop (to load the latest version, possibly customized and/or chosen from several optional versions).

When said processing comprises testing of said electronic devices, the same advantages as mentioned for the corresponding system claim are achieved.

When said tests of said devices are performed synchronously, test of synchronous suited properties are ensured with optimal performance.

When said tests of said devices are performed sequentially, test of sequential suited properties are ensured with optimal performance.

When said tests of said devices are different for different devices, it is ensured that a very flexible method is provided, allowing a 'built to order' flow of personalized devices with different properties to be tested in the same chamber and on the same production line.

When said processing comprises downloading of the enabling software to said devices as a last step in the production process, while said devices are individually packaged in their final package, it is ensured that the same advantages as mentioned for the corresponding system claim is achieved.

When said processing comprises test of radio properties of said electronic devices as well as test of acoustic and optical properties of said devices, it is ensured that the same advantages as mentioned for the corresponding system claims are achieved.

When said tests are carried out at different environmental conditions, it is ensured that a time saving process is provided, possibly combining the simultaneous tests of radio properties with acoustic and optical tests, with vibration tests over temperature, humidity, etc. for the same batch of devices, thus saving time and improving reliability (and thus quality) of the devices.

When said processing comprises measuring the average output power of each of said radio communications devices by rotating one of said at least one stirrer, and averaging the results of several measurements for each rotation of said stirrer, it is ensured that a convenient and rapid method of testing fundamental radio properties of the devices is provided. The method of determining average output power of a radio communications device may also be used on a single unit in a mode-stirred chamber.

When said processing comprises determining the radiation efficiency of each of said radio communications devices by making a measurement of average received power for each device and comparing it with a corresponding measurement using a reference antenna with known radiation efficiency, it is ensured that an accurate method of determining a key parameter of a radio communications device in an economical, fast and reproducible manner is provided. The method of determining radiation efficiency of a radio communications device may also be used on a single unit in a mode-stirred chamber.

The present measurement of the radiation efficiency of an antenna can be used for any type of antenna - external or internal antenna at any frequency band. For an antenna in a multi-path environment with multiple reflection wave propagation, the radiation patterns do not have any great importance. It is more important that the antenna radiation efficiency averaged over every angle of incidence is as high as possible. High radiation efficiency is also important in order to keep the power consumption reasonable. The radiation efficiency test in the mode-stirred chamber is performed in the following way (the device under test being in a receive mode): First, measure the received average power of an antenna with known radiation efficiency from a signal transmitted into the chamber from another antenna. Then without changing the transmitting antenna and feeding cable and maintaining the same input power into the chamber, measure the received average power for the antenna of the device under test (DUT). In order to increase the accuracy of the measurement, it is suggested that the antenna under test is measured in several positions and that the results are averaged. It does not matter whether the antenna under test is in transmit or receive mode. It may be practical to use a battery powered transmitter to feed the reference antenna and the antenna under test, since this scheme avoids feeding cables, thus eliminating the influence of currents in or on the shield of feeding cables.

When said processing comprises determining the specific absorption rate (SAR) of each of said radio communications devices by performing the steps of creating a numerical model of the radio device type and its interaction with a phantom body, determining the radiation efficiency of each of said radio communications devices in a mode-stirred chamber, and calculating the SAR value for each device using said numerical model and individual values of radiation efficiency, it is ensured that a fast and economical method of determining SAR is provided.

There is a number of national and international regulations, standards and recommendations dealing with exposure to radio frequency electromagnetic fields. The limits are generally very similar and usually based on recommendations from the World Health Organization (WHO) and the International Radiation Protection Association (IRPA).

When a radio transmitter is close to a person - e.g. if he or she is using a mobile telephone - and the exposure is local, the highest power absorption per unit mass in a small part of the body must be established and compared with the basic limits given in the standards.

The SAR value of a radio device may be defined in the following way: Exposure limits applicable for handheld mobile phones are expressed as local peak Specific Absorption Rate (SAR) expressed in Watt/kg, averaged over a small mass (1 or 10 grams) of tissue. SAR is thus a measure of the radio frequency power absorbed by the human body.

It should be emphasized, though, that there is no evidence indicating that it is dangerous to the human health to use a mobile telephone.

Existing SAR test equipment is very expensive and has a long delivery time from the producers of such equipment. In the early development phase as well as for production tests it is of interest to have a cheaper and quicker measurement method available. In particular it is convenient to be able to measure SAR under different environmental conditions by combining the use of the mode-stirred chamber with the use of a climatic chamber.

The suggested method of measuring SAR is a faster method than the conventional method of measuring SAR. It also gives more repeatable measurements and can be used to compare different device models. The suggested method will combine the strengths of numerical modelling of the device and the user interaction with the fast possibility of measuring the antenna radiation efficiency inside the mode-stirred chamber. It is not necessary to use the phantom head and the artificial hand in the measurement and this will save time and money. A database of device-to-user interaction formulas can be created, and this database may be used to predict the peak SAR values from the measured antenna efficiencies.

The disclosed method of determining the specific absorption rate of a radio communications device may also be used on a single unit in a mode-stirred chamber.

In a preferred embodiment said processing is performed at different frequencies.

The use of a chamber for processing electronic devices is moreover provided by the present invention. When several devices are handled simultaneously and said processing comprises a transfer of airborne signals, the same advantages as mentioned for claim 1 are achieved.

**Brief Description of the Drawings:**

The figures will be described in the following, in which

figure 1 shows a mode-stirred chamber with access through an EMC door, and

figure 2 shows a mode-stirred chamber with openings made as waveguides, and

figure 3 shows a mode-stirred chamber including a receiving antenna, a transmitting antenna, and a stirrer, and

figure 4 shows a mode-stirred chamber with openings made as waveguides, where the mode-stirred chamber includes two stirrers, a base station, a radio tester, and a camera, and

figure 5 illustrates the CDF of normalized power referenced to mean in a mode-stirred chamber, and

figure 6 illustrates the PDF of the normalized power referenced to mean in a mode-stirred chamber, and

figure 7 illustrates the CDF of max to mean of chisquare distribution for N=20, 50, 100, 200, 500, and

figure 8 illustrates the results of a typical measurement of received power versus stirrer position at 2.40 GHz in a mode-stirred chamber, and

figure 9 illustrates tuner sweep data of fig. 8 referenced to the mean received power, and

figure 10 illustrates a comparison between measured and chisquare distribution, and

figure 11 illustrates correlation versus offset, and

figure 12 illustrates the CDF of max to mean for chisquare for N=10, 20, 40, 83, 200, and

figure 13 shows a flow chart for the measurement of Specific Absorption Rate (SAR) of a radio device in a mode-stirred chamber according to the invention, and

figure 14 shows a flow chart for the measurement of average received power in a mode-stirred chamber according to the invention, and

figure 15 shows a flow chart for a reference measurement in a mode-stirred chamber according to the invention, and

figure 16 shows a flow chart for a test of radio devices in parallel according to the invention.

**Detailed Description of Embodiments:**

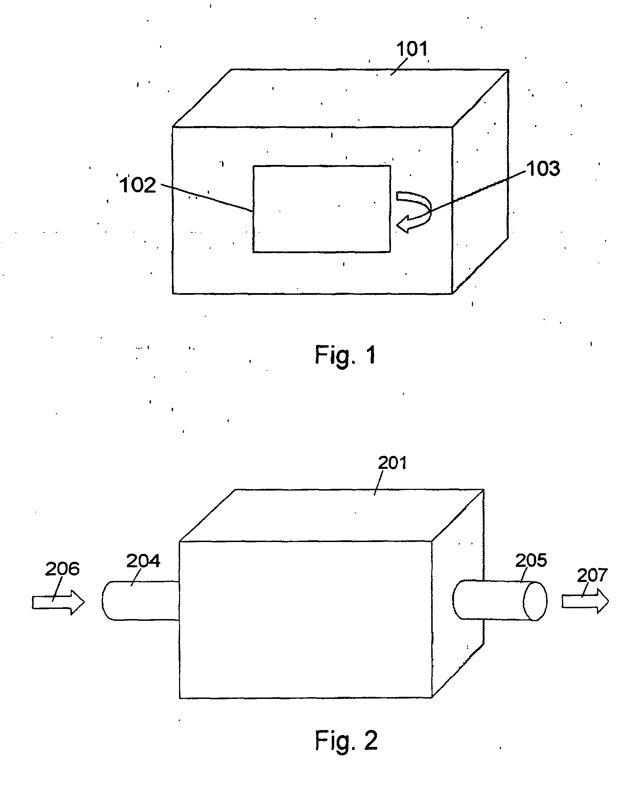

Figure 1 shows a mode-stirred chamber 101 with an EMC door 102, which is to be opened outwards 103.

A batch of electronic devices can be positioned in the mode-stirred chamber 101 for simultaneous testing and/or simultaneous software download. The electronic devices enter the mode-stirred chamber 101 through the EMC door 102. The EMC door 102 has shielding properties for radiation between the exterior and the interior of the mode-stirred chamber 101.

Figure 2 shows a mode-stirred chamber 201 with two openings made as waveguides 204, 205. The waveguide 204 is an entry 206, and the waveguide 205 is an exit 207.

Electronic devices continuously or discontinuously flow into the mode-stirred chamber 201 through the waveguide 204, through the mode-stirred chamber 201, and finally out through the waveguide 205. During the period the electronic devices are inside the mode-stirred chamber 201, simultaneous testing and/or simultaneous software downloading takes place for the electronic devices. The physical dimensions of the waveguides 204, 205 are defined in order to get a cut off frequency above the highest radiation frequency used inside the mode-stirred chamber 201. The waveguides 204, 205 therefore efficiently shield against radiation to the outside of the mode-stirred chamber 201.

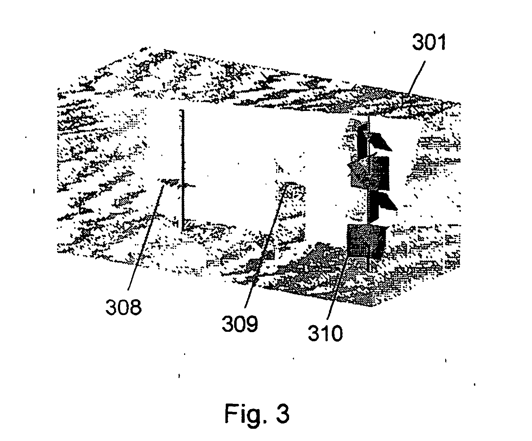

Figure 3 shows a mode-stirred chamber 301. Inside the mode-stirred chamber 301 are a receiving antenna 308, a transmitting antenna 309, and a stirrer 310.

The transmitting antenna 309 and the stirrer 310 are part of the mode-stirred chamber 301. The receiving antenna 308, which represents the device under test, is exposed to radiation from the transmitting antenna 309. By rotating the stirrer 310, the radiation becomes homogenous and isotropic.

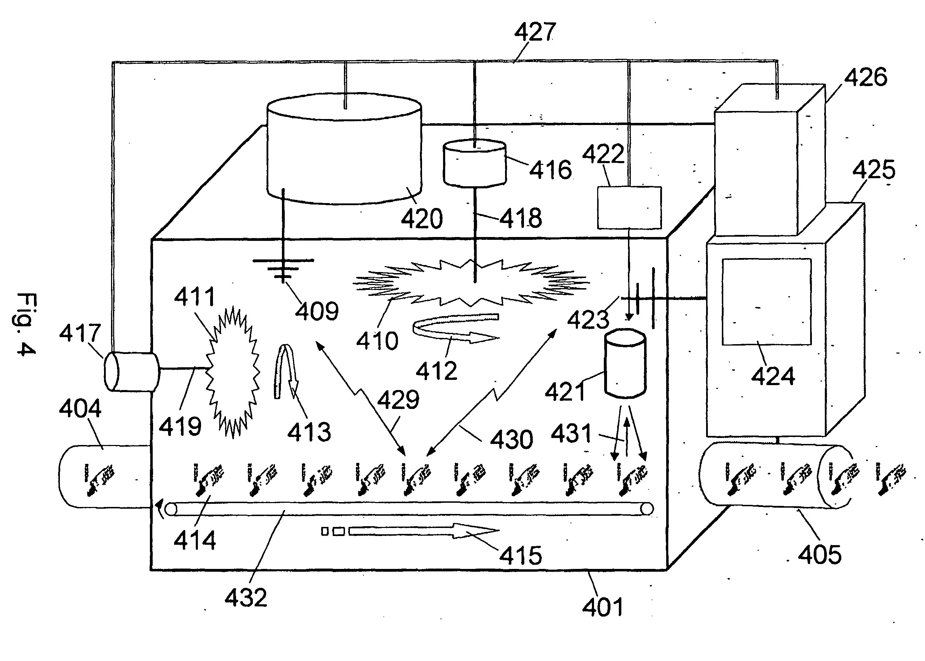

Figure 4 shows a mode-stirred chamber 401 with two openings made as waveguides 404, 405. The mode-stirred chamber 401 includes two stirrers 410, 411. Stirrer 410 is connected to a motor 416 via a shaft 418. Stirrer 411 is connected to a motor 417 via a shaft 419. Arrows 412, 413 indicate rotational directions of the stirrer 410, 411. Mobile telephones 414 pass through the mode-stirred chamber 401 in the direction indicated by arrow 415. An antenna 409 is connected to a base station 420. The base station 420 and antenna 409 may in a preferred embodiment comprise a base station and antenna for Bluetooth as well as a base station and antenna for a digital mobile communications system such as GSM (Group Special Mobile or Global System for Mobile communication). A camera 421 is connected to a vision camera interface 422. An antenna 423 for receiving radio signals from the devices under test is connected to a radio tester 424 inside a rack 425. A personal computer 426 is connected to the motors 416, 417, the base station 420, and the vision camera interface 422 via a data link 427.

Mobile telephones 414 continuously or interrupted flow into the mode-stirred chamber 401 via the waveguide 404, through the mode-stirred chamber 401 in the direction indicated by the arrow 415, and finally get out via the waveguide 405. The waveguides 404, 405 have a cut off frequency above the radiation frequency inside the mode-stirred chamber 401. Therefore, the waveguides 404, 405 efficiently shield against radiation to the outside of the mode-stirred chamber 401, while allowing a flow of devices in and out of the chamber. In a preferred embodiment, a conveyor 432 consisting of a dielectric support material for supporting said electronic devices is used for automating the entry and exit of devices to and from the chamber. The base station 420 sets up calls 429 in parallel to the mobile telephones 414 using antenna 409. These 'calls' may in a preferred embodiment be set up in the Bluetooth band as well as in a GSM band to each telephone using different channels for each device. By rotating the stirrers 410, 411 the radiation becomes homogenous and isotropic. In a preferred embodiment, basic software for enabling the test and/or for providing the telephone with its full final software is downloaded in parallel into the mobile telephones 414 via the Bluetooth interface (i.e. the base station 420 and antenna 409 and corresponding Bluetooth receive modules in the telephones (not shown)). In a preferred embodiment, test pattern and test data are transmitted between the mobile telephones 414 and the base station 420 and antenna 409 via the Bluetooth interface. Transmission to the mobile telephones 414 is performed in parallel. The mobile telephones 414 are inspected for vision properties 431 by the camera 421 connected to the vision interface 422. Acoustical properties of the devices are tested by using the built-in microphone and loudspeaker, e.g. by checking whether an acoustic test signal is properly received by the microphone of the device in question. Alternatively, a separate microphone may be placed in the chamber (not shown) to pick up the test signal from the device, said microphone being connected to the PC for analysis of the received data. Alternatively, a voice interface on the telephones may be tested while located in the mode-stirred chamber. The personal computer 426 controls the rotation of the stirrers 410, 411 via the data link 427. The personal computer 426 controls the set-up of calls at the base station 420 via the data link 427. The personal computer 426 manages test pattern and test data 429 transferred via the Bluetooth interface and the mobile telephones 414 and the received radio data 430 via antenna 423 and radio tester 424. Likewise, the personal computer 426 manages the vision interface 422 with received optical data 431 and the acoustic measurements via the data link 427.

In a preferred embodiment a second stirrer is introduced in the mode-stirred chamber. This stirrer will have the task of altering the resonance conditions, for each continuous sweep with the "main stirrer". This means it should be stepped.

In another preferred embodiment, several antennas are used to sample the received power from the device under test at the same time to improve measurement accuracy.

In a preferred embodiment of the invention several phones are tested in parallel using different channels and using several receive antennas and several analysing instruments at the same time.

In a preferred embodiment of the invention dual mode (or higher mode) phones, e.g. GSM/AMPS (AMPS = Advanced Mobile Phone Service) devices, are tested in parallel using different channels for each device, each mode being sequentially tested (e.g. all phones under test are first put in GSM mode and tested using a GSM test program and afterwards put in AMPS mode and tested using an AMPS test program).

In a preferred embodiment, the minimum physical spacing between the devices under test and the minimum channel (frequency) distance are determined with a view to achieving a certain level of accuracy of the measurement results.

In a preferred embodiment the mode-stirred chamber is combined with a climatic chamber so that the tests may be carried out in at different environmental conditions as regards temperature, humidity, etc. In a further preferred embodiment, a special inner chamber (not shown) around the line of devices under test, e.g. surrounding the conveyor 432 and the devices under test 414, is provided. The inner chamber is constructed so that its walls are appropriately transparent to the electromagnetic waves constituting the carriers of the test signals. This has the advantage of minimizing the volume that has to be environmentally cycled, thus lowering the time constants involved in the cycling. In a further preferred embodiment, the chamber is provided with a vibrator (not shown) to be able to simulate mechanical vibrations of the devices under test and/or to introduce additional mode-stirring.

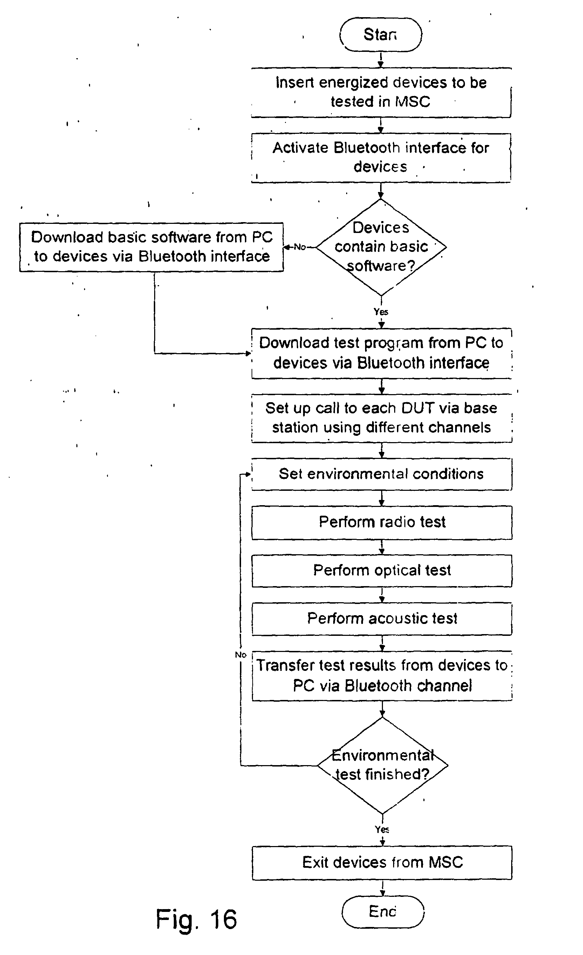

In figure 16, a flow chart for a procedure for testing radio devices (e.g. mobile telephones) in parallel in a mode-stirred chamber is outlined.

In the following, elements of the theory of the mode-stirred chamber together with some helpful rules of operation are outlined.

A simple matlab program has been developed to compute the discrete resonance frequencies of a general rectangular box of dimensions a, b, d, which are given by equation 1 in which i, j and k are integers and a, b and d are the dimensions of the box.

Discrete resonance frequencies exist for the cases when at least two of the indices are non-zero. When all indices are non zero, both a TE and a TM resonant mode will exist at the same frequency. The cut off frequency of the box (the lowest frequency which can exist in the box) is given, assuming that a and b are the two largest dimensions for i=1, j=1 and k=0. A mode-stirred chamber need not be rectangular in shape, but most of the existing chambers have a rectangular shape.

When designing a mode-stirred chamber, the dimensions of the walls should have non-multiple dimensions, i.e. a wall should not have a length of exactly an integer multiple of the other. The reason for this is that this results in mode degeneracy. Standing waves can then exist at the same frequency for several dimensions, and this is an inefficient use of existing volume and more seriously can create mode gaps. The calculations have been done in a simple matlab code. The program is generic, so it is possible to study the influence of different sizes on the resonances in a box.

For a mode-stirred chamber of size a·b·d adapted for the Bluetooth band, 2.40-2.50 GHz, the total accumulated number of modes up to this frequency is slightly more than 700 (for a = 1.0 m, b = 0.5 m and d = 0.5 m) . The Weyl formula for the total number of resonant frequencies N(f) is given by:

$$N(f) = \frac{8\pi}{3} \cdot a \cdot b \cdot d \cdot \left(\frac{f}{c_0}\right)^3 - (a+b+d) \cdot \left(\frac{f}{c_0}\right) + \frac{1}{2} \qquad \text{Equation 2}$$

An expression can be derived from equation 2, to get the mode density, i.e. the number of modes per frequency:

$$\frac{dN}{df} = 8 \cdot \pi \cdot a \cdot b \cdot d \cdot \left(\frac{f^2}{c_0^3}\right) - (a+b+d) \cdot \frac{1}{c_0} \qquad \text{Equation 3}$$

The equations above are useful for rapid calculations of rectangular boxes. Sometimes equation 2 above is called Weyl's equation. N(f) is the total number of modes from cut off up to a frequency f. The mode density dN/df is also of interest, but note that these expressions are analytical functions which are continuous, but the true resonant modes are discrete and can be calculated from equation 1. In the high frequency limit, there is a convergence between the Weyl equation and the discrete modes, which are computed from equation 1.

The use of computing the discrete modes is limited, it can however be used particularly at low frequencies in the design of a mode-stirred chamber in order to avoid mode gaps in the bands to be measured. There are some "rules of thumb" concerning the "lowest usable frequency" for a mode-stirred chamber.

Sometimes it is expressed that the lowest usable frequency is 5-6 times the cut off frequency, and sometimes it is claimed that at least a few hundred modes must exist in order to get the desired homogeneous and isotropic field distribution which has a so called chisquare distribution. At 2.5 GHz, the box under test contains more than 700 resonant modes and the ratio to cut off is 7.2, so we can conclude that it is with a margin big enough for Bluetooth, in fact even big enough for GSM1800 and WCDMA as well. For GSM900, however, we see that the total number of modes is too small to have a chisquare field distribution. For this purpose a larger chamber is needed. The box is also tested at 1800 MHz and 900 MHz to check how well the distribution at these lower bands agrees with a chisquare distribution. For some applications a "zoomed" plot of the mode positions in the frequency band of interest, such as Bluetooth, may be of particular interest. As mentioned above, the distribution of the received power in a mode-stirred chamber can be described by the chisquare distribution. It is often convenient to normalize the measurement data to the mean value and compute so-called cumulative distribution plots of the received power and compare the measurement data to the theoretical chisquare. When working with the data from a mode-stirred chamber, we often want to compare the data with statistical expressions of type probability density functions (PDF) and cumulative distribution functions (CDF). Sometimes data is analysed in linear terms, but more often we use the logarithmic expressions due to the great dynamic ranges involved. Both the probability density function and cumulative distribution function distributions can be presented as normalized data to the mean or presented as distributions of the max to mean data. Therefore, there are four important equations to use:

$$PDF(\chi^2_{2DOF/\mu}) = 0.23 \cdot \exp(\frac{x}{4.34}) \cdot \exp(-\exp(\frac{x}{4.34})) \qquad \text{Equation 4}$$

$$CDF(\chi^2_{2DOF/\mu}) = 1 - \exp(-\exp(\frac{x}{4.34})) \qquad \text{Equation 5}$$

$$PDF^{\max}_{mean}(\chi^2_{2DOF/\mu}) =$$
$$\frac{N}{4.34} \cdot \left[1 - \exp(-\exp(\frac{x}{4.34}))\right]^{N-1} \cdot \left[\exp(-\exp(\frac{x}{4.34}))\right] \cdot \exp(\frac{x}{4.34}) \qquad \text{Equation 6}$$

$$CDF^{\max}_{mean}(\chi^2_{2DOF/\mu}) = \left[1 - \exp(-\exp(\frac{x}{4.34}))\right]^{N} \qquad \text{Equation 7}$$

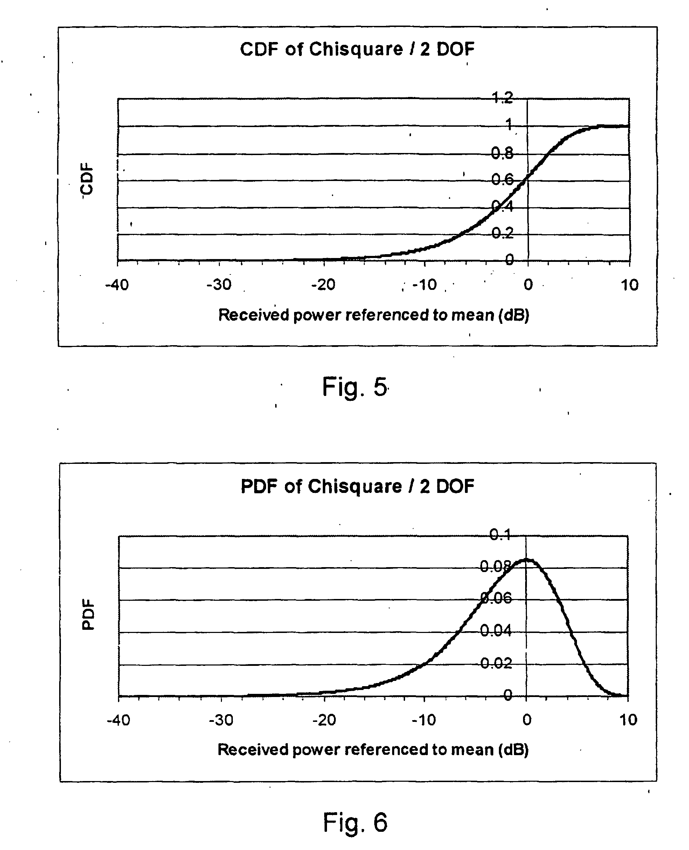

In equations 4-7 above, the distributions are normalized to the logarithm mean value (m) of the received power. Note that the above four equations are valid, assuming logarithmic data, and that they also assume that we measure the received power. A mode-stirred chamber of proper design will show a distribution of the mean-normalized received power which will have a good consistency with values predicted by equation 5 above. To illustrate how the curve looks it is plotted in figure 5.

It is also convenient to plot the probability density function of the data referenced to mean by equation 4, as illustrated on figure 6.

For the received power, the distribution is chisquare with two degrees of freedom. Assuming instead that we measure the received field, then the distribution is chi with six degrees of freedom. An E-field probe with three axes is then needed. For most applications, however, we measure the received power and need to deal only with the above four equations. An important parameter of a mode-stirred chamber is the number of independent samples (IS). This parameter is measured by computing the correlation coefficient between "shifted data vectors" of the received power versus the offset and counting the number of the offset which must have a correlation coefficient less than 1/e (0.37).

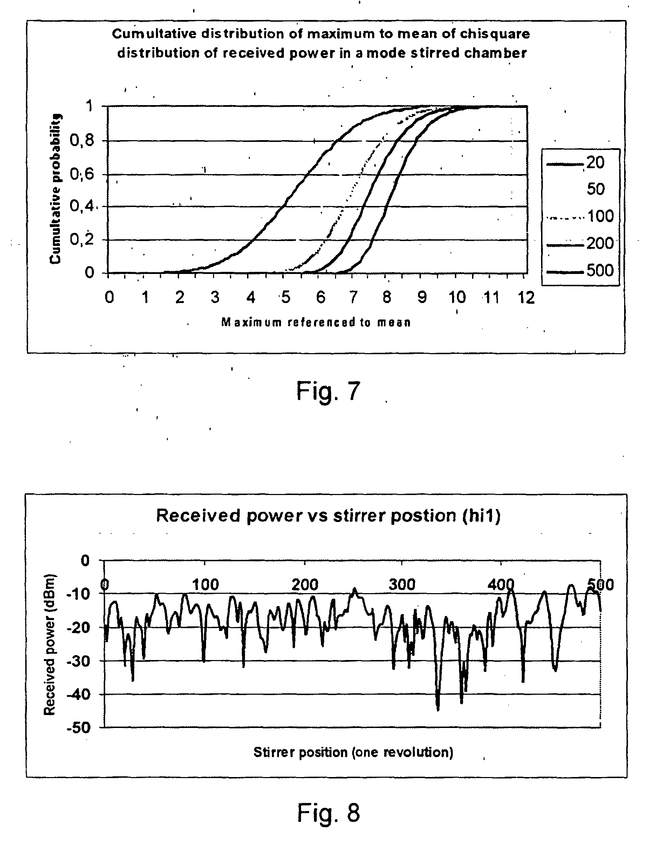

When testing, it is important to know this for planning how many tuner steps or how many frequencies are needed. We want to select the right number, given the acceptable risk of under/over testing. Too many steps compared to the needed accuracy just increase the time of measurement. Plotting the theoretical cumulative distribution function for the maximum referenced to the mean of the log data for different number of independent samples N is shown in figure 7 for N=20, 50, 100, 200, 500.

An example of analysis of a tuner sweep from the mode-stirred chamber will now be discussed, from the measurement, to the chisquare comparison equation 5, and the deduction of the number of independent samples (N). The comparison between what is predicted from equation 7 and the actually measured max to mean ratio of the received tuner sweep is then performed.

A typical tuner sweep of the received power for one revolution of the stirrer is shown in figure 8.

The EMCO horn antenna was used as the transmitting antenna, and a Bluetooth antenna from Moteco of the swivel type was used as the receiving antenna. The data presented in figure 8 is converted into linear format, and the average of the received power is computed, and the data is presented referenced to the mean received power in dBm, i.e. in dB referenced to mean. The reason for this is that the format which we are using from equation 5 assumes that the data has been normalized to mean in the logarithmic format.

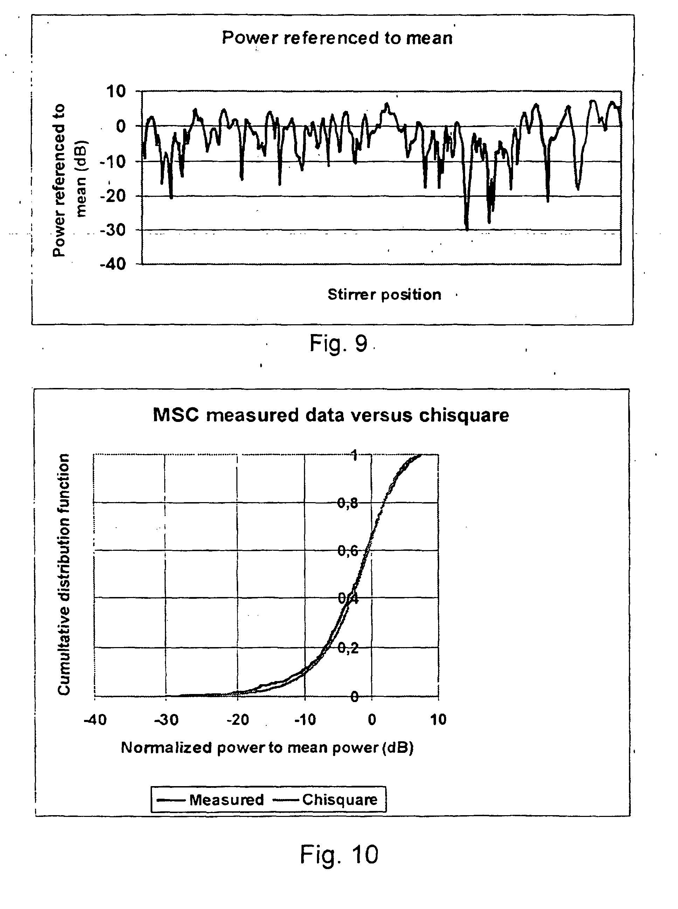

Note that figure 9 is just shifted compared to figure 8, but now the data is in dB referenced to the mean value, instead of absolute data in dBm.

A few parameters are of special interest to immediately check on the trace:

- The mode-stirring ratio (the ratio in dB between the max and min received power). This value should be at least 20-30 dB. In this case it is 35 dB.
- The standard deviation of the normalized data should be close to 1.0.
- The ratio of the max to mean of the received power (dB). From this ratio, it is possible to deduct the number of independent samples in the mode-stirred chamber, which is the number of different uncorrelated field distributions. The greater this value, the greater the max to mean ratio. Typical values are 4-10 dB.
- The average of the received power is an important property, since this value is computed to normalise the data for the chisquare comparison, but also for the comparison with absolute measurements of radiated emission and antenna efficiencies for example.

The values for the measured trace are 37 dB for the mode-stirring ratio, the standard deviation was 1.056, and the max to mean ratio was 7.3 dB. After checking that these parameters are close to the desired ones, we then conclude by sorting the mean normalized data of figure 9 from lowest to highest power and then plot this data and compare it to the theoretical chisquare plot of equation 5. The result, after normalizing and sorting the data and plotting the measured data in comparison to theory, is shown in figure 10.

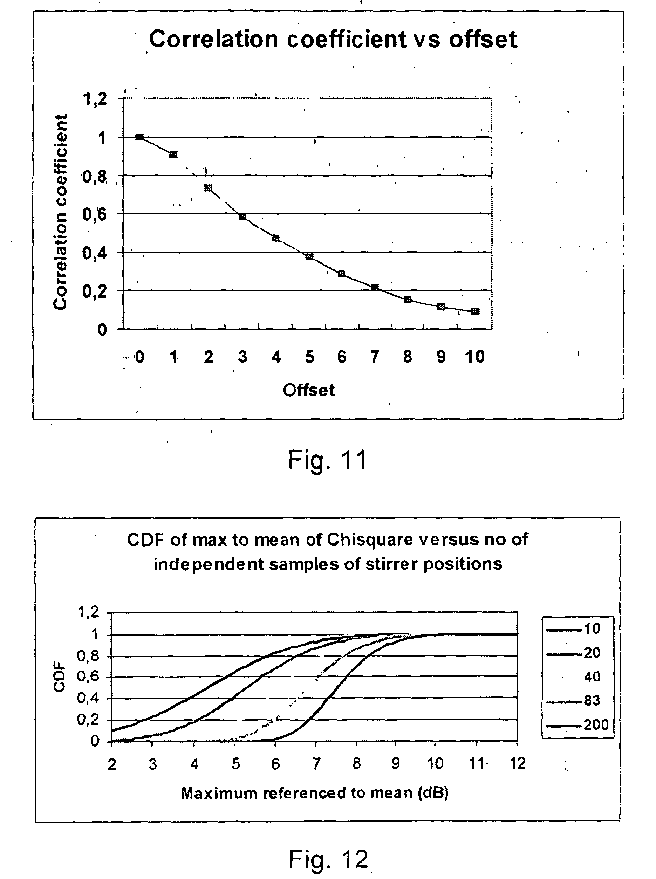

The number of independent samples, discussed above, can be computed in several ways. One way is to compute the correlation between different received power data vectors, in which the vector is shifted one data point. The number of shift offsets which are needed to obtain a correlation coefficient below 1/e, is sometimes used as a criterion that the data is uncorrelated. Performing this operation on the measured data of figure 10, and presenting the correlation coefficient versus the number of shifts, we obtain the result shown in figure 11.

A shift of six data points in the spectrum analyser power trace results in a correlation coefficient less than 1/e (0.37). From the number of data points in the analyser trace, which was 500 points in this case, we then can deduce the number of independent samples from the ratio 500/6 which is 83. The conclusion from this analysis is that we do not sample too sparsely. The sampling rate is large enough. This is important, since the deep fading of the received power can cause a problem, if the sampling rate is insufficient. Note that the tuner sweep is for one revolution of the stirrer, after which the pattern repeats itself in a periodic pattern. For 83 samples considered independently, this means that the stirrer must be rotated at least 360 degrees/83 = 4.3 degrees in order to cause a field distribution, which is uncorrelated to all others. Now, it may be of interest to use the number N=83 in equation 7 and see what is the predicted max to mean ratio for this number of independent samples. By 'predicted', we mean the "x-value" in figure 12, for which the computed curve for N=83 has a cumulative distribution function value of 0.6. The curve for N=83 is shown in figure 12 together with a few more values for N.

From the curve for N=83 (the second from the right), we read that it crosses CDF=0.60 for the x-value of 7.1 dB, which is in close agreement with the measured max to mean value of 7.3 dB.

In the following, basic information on measurements in a mode-stirred chamber on mobile telephones using Bluetooth will be disclosed, demonstrating the feasibility of the use of the mode-stirred chamber according to the invention for the simultaneous test of mobile telephones.

The devices under test were prototype phones. They are powered by battery and internally they have Bluetooth transmitter chips. The Bluetooth channels 02..80 were set by using a simple terminal program in a PC, which was hooked up to the device under test by the PC port, a cable and a special so-called NOR adapter. A dielectric support was made, on top of which the device under test was placed during the measurement. It is important that the device under test is not too close to the wall during the measurements. This may imply that the Bluetooth amplifier can be loaded in a way which can affect the output power.

Before starting to measure the effect of moving the phones under test and turning them inside the mode-stirred chamber in great angles, a few sets of experiments were performed to check the repeatability of the measurement method of making the tuner sweep with a spectrum analyser (SA). The device under test was set at the channel under test and the spectrum analyser was set at the same central frequency as measured to its peak from an antenna. The sweep time of the spectrum analyser was set to be the same as the rotation time of the stirrer. The received power was measured versus time, the data was then converted to linear and the mean value was calculated and converted back to dBm. What is interesting to compare is the average received power in dBm over one turn of the stirrer.

The stability of this measurement has been evaluated by first measuring the devices under test for several sweeps of the tuner, without moving the device under test. In a second set of sweeps, the device under test was removed and manually replaced roughly in the same position by hand. In the second experiment, we were interested to see the possible effects of the operator replacing the device under test slightly differently and also possibly tightening the bolts of the EMC door a little differently from run to run. The first case is a kind of idealistic test of the instruments and the averaging method as well as the stability of the output power from the device under test perhaps as well. The second test, besides the above effects, also puts the light on a possible operator effect, which may distort measurements. Note however that the device under test was just roughly manually placed back on the support, without any alignment. So therefore, the results could be improved if needed.

The result of a measurement series of a total of ten sweeps, for which the phone was not moved during the test, shows that the maximum deviation is less than 0.1 dB.

For the test, in which also the effects of the operator reloading the phone under testing and opening and closing the EMC door, one would expect to see a greater variation in the results since it is not fully automatic, and therefore there may be slight variations in the manual loading of the chamber which may effect the measurement results. The maximum deviation in this case, for 20 measurements of the received power, after manually removing and replacing the phone, was about 0.50 dB and the standard deviation was 0.13 dB.

It is concluded from these measurements that for most measurements the effects of the sampling and averaging procedure of the measurement data are probably negligible compared to other measurement uncertainties. The effect of the operator on the results can, however, influence the results up to 0.5 dB in the worst case, but the standard deviation of the data spread is lower.

The intention of these experiments was to demonstrate the degree to which the mode-stirred chamber complies with the quasi-homogeneous field distribution, i.e. how much the actual position of the device under test inside the mode-stirred chamber may influence the measurement results. The devices under test were moved to different positions, but keeping their angular orientation constant. The measured average received power for the phones placed at two different positions was measured. In each position, the phones were measured at three different angles in the horizontal plane.

The isotropy of the field distribution inside the mode-stirred chamber theoretically indicates that the average received power should be independent of the angular orientation of a transmitting device under test. The results show that the isotropy was better than 1.5 dB in a condition where no absorber material was used in the chamber. Placing a piece of absorber material in the chamber improved the isotropy to be better than 1.0 dB.

The average received power was measured as a function of the angle. The device under test was manually rotated in steps of 45 degrees. The uniformity in received power is in general better than 3 dB. Experiments to determine the efficiency of the antennas inside the phones at channel 02, 40, 80 were carried out with the aim of investigating the possibility of quickly measuring the antenna efficiency for the internal Bluetooth antenna in the prototype phones and particularly of comparing it with the results from other measurement methods. The measurement accuracy will in general be limited by the degree of deviation from the "ideal" mode-stirred chamber. In practice, the chamber will not have a perfect homogeneous and isotropic field environment, and it may be necessary to make several measurements to achieve measurement accuracy below 1 dB.

The relative measurements of antenna efficiency versus channel and field homogeneity and isotropy do not require an absolute calibration of the chamber. For measurements of absolute radiated power however, a calibration measurement is needed of course. The method of performing this type of calibration comprises the following steps:

1. Use a transmit antenna to inject a known power into the chamber and measure the received power versus stirrer position using a receive antenna. When estimating the known input power, information about the transmit cable attenuation and the antenna efficiency of the transmit antenna is needed. If this is not known, it is suggested to use a (linear) efficiency of 0.90 for a horn antenna and 0.75 for a log-periodic antenna.

2. Replace the transmit antenna and insert the device under test into the chamber. If known, the radiation pattern from the device under test should be "pointed" into a corner of the chamber, to minimize the direct coupling to the receive antenna. The receive antenna and receive cable should not be moved from the calibration to the actual measurement. The measurement should be repeated for several positions of the device under test, to make sure that the results are within an acceptable variation margin (due to non-perfect homogeneity).

3. It is the average received power which is of interest, and it may be necessary to estimate the levels of the received power from the device under test before doing the calibration, so that the calibration is made in the right dynamic range. The path loss on average in this particular chamber is between 15-20 dB, depending on type of antennas and positioning. The average received power should be computed for tuner sweeps of different power levels injected into the chamber.

In the following, parallel measurements on two different types of cellular telephones are disclosed, hereafter termed 'phone 1' and 'phone 2'. The phones are powered by battery and inserted into the mode-stirred chamber at the same time, at a distance of about 10 cm between each other on a dielectric support material. The frequency of 'phone 1' was set at 2.402 GHz and of 'phone 2' at 2.440 GHz. Two Bluetooth antennas from Moteco of the swivel type were used as receiving antennas. The devices under test were not placed in a position so that the stirrer blocked the path between the test objects and receiving antennas. The receiving antennas did not point directly at the test objects, however. The two spectrum analysers were trigged simultaneously from an external pulse generator, and the received power from the two different phones was measured by picking up the radiation with the two Bluetooth antennas. The two spectrum analysers were set at the transmitting frequencies 2.402 and 2.440 GHz. The stirrer speed was 10 seconds per revolution, which was the same as the sweep time of the spectrum analyser.

First the power was sampled from both phones with the two instruments at the transmitting frequencies, then one of the phones was removed and the power was measured for only one phone. The procedure was then reversed, so that only the other phone was transmitting. The result was as expected, namely that the received power was the same, both in the case of the other phone transmitting at another frequency and in the case of the other phone being absent. So for a static transmission test at this channel spacing of 40 MHz, the two phones do not influence each other in the transmission.

Another test was carried out, comprising setting both phones at the same frequency and studying the power envelope versus time. As expected, the mode-stirring ratio decreased and there was a greater deviation from the chisquare distribution. The reason is that, with two transmitters at the same frequency, the received signal versus time is the sum of the two signals and the deep fadings are reduced. If there is a deep fading from the signal received from one phone, then the probability of a fading from the other phone is low, since that one is at another position. Nevertheless, there was still a measured mode-stirring ratio of almost 20 dB, which is surprisingly high. The conclusion is that, when measuring in parallel, it is preferable that the devices under test operate at different frequencies.

The received power from the two phones transmitting at 2.402 GHz and 2.440 GHz was measured with the spectrum analyser set in frequency sweep mode at a centre frequency of 2.42 GHz and a span of 100 MHz. The received signals in the two different antennas were recorded for two different fixed positions for the tuner.

It is observed that the power received from the two receiving antennas is different (since they are at different positions), and also that moving the stirrer to a new fixed position will change the amplitude. When measuring several phones in parallel, it is preferable to use several receiving antennas, for two reasons. Firstly, measuring at several frequencies at the same time can increase the speed of measurement. Secondly, the measurement accuracy can be improved, if needed, by measuring more samples of the received power.

The following summarizes some ways of reducing the uncertainty of measurements on mobile phones in a mode-stirred chamber:

- Measure the device under test in several positions.
- Use several stirrers inside the mode-stirred chamber to increase the randomness.
- Use field diffusers inside the chamber.
- Measure the device under test by several receive antennas simultaneously, note that a calibration file is needed for each receive antenna and receive cable.
- Increase the size of the mode-stirred chamber.
- In some cases it may be relevant to use absorbing materials inside the mode-stirred chamber to reduce the Voltage Standing Wave Ratio (VSWR), but the power density distribution should be checked and compared to chisquare.

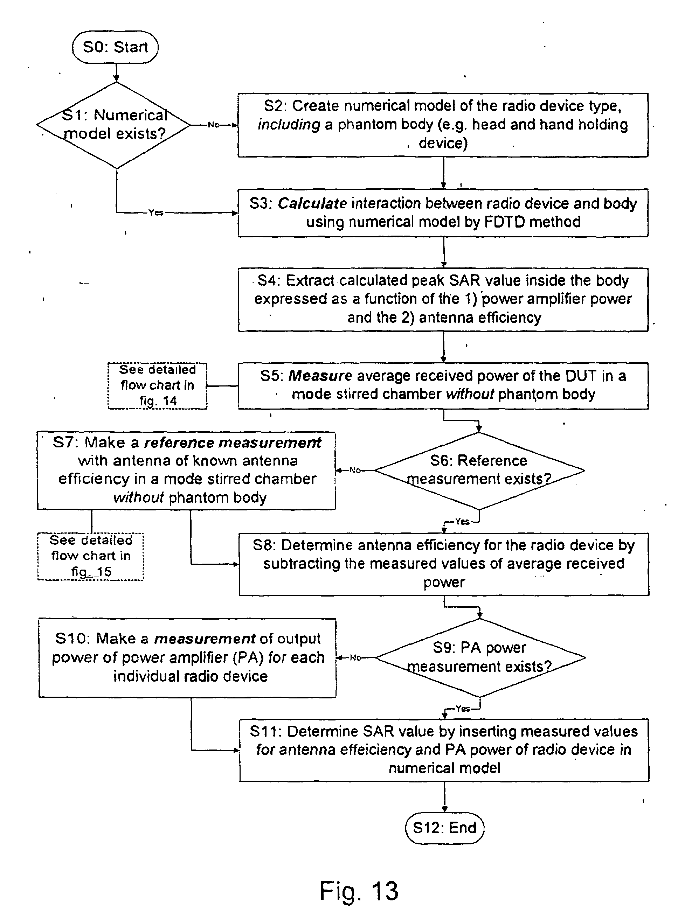

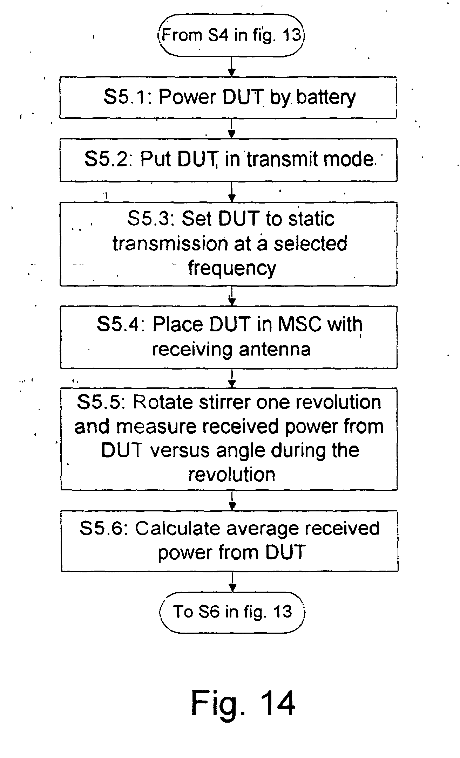

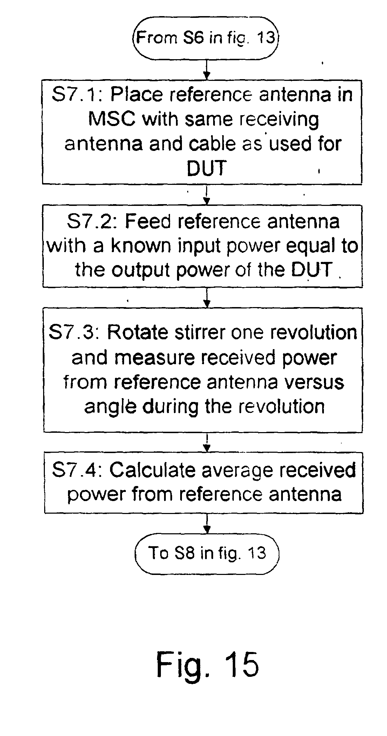

Figures 13, 14 and 15 show flow charts for a method of measuring radiation efficiency and specific absorption rate (SAR) of a mobile telephone in a mode-stirred chamber.

This new suggested application of the mode-stirred chamber to determine SAR values of mobile telephones uses the relationship between the antenna radiation efficiency and the SAR value of a mobile telephone. The suggested method of determining SAR values of mobile telephones is based on a combination of numerical modelling and experimental measurements. First, a numerical model of the mobile terminal, including a phantom head and an artificial hand holding the terminal, is made. In the numerical model, the interaction between the handset and the user is calculated by the finite difference time domain (FDTD) method. The net result from this calculation will be the peak SAR value inside the head, and it can be expressed as a function of the Power Amplifier (PA) power and the antenna radiation efficiency. The antenna radiation efficiency will vary with frequency and it will not only depend on the antenna, but the whole phone board and the chassis will have an influence on the efficiency. In the numerical model, it is assumed that the phone is placed in the normal talk position. The influence of how the phone is held by the hand and the position relative to the head can be studied in the numerical model, including how it will influence the peak SAR value inside the head. In principle, it should also be possible to calculate the voltage standing wave ratio (VSWR) at the antenna feeding point inside the phone in the user position - but this may require a very detailed model of the phone and the user.

The next step in the method is to experimentally measure the antenna radiation efficiency of the phone, including the board and the chassis. This measurement is performed in the mode-stirred chamber, and, in this measurement, the phantom head and the artificial hand shall not be included. The phone under test is put in transmit mode and is powered by a battery and set at static transmission at a selected frequency. The phone under test is then inserted into the mode-stirred chamber, and the door is closed, and the stirrer is rotated one revolution. The received signal from the phone under test is picked up by a receive antenna, and the average value of the received power is computed by a processing unit (e.g. a PC or any other appropriate analysing device). A reference measurement is then performed, using a reference antenna (such as a dipole) with a known efficiency. By feeding the reference antenna with a known input power from a signal generator and picking up the received power with the same receiving antenna and cable (as used for the phone under test) to the recording and averaging instrument, it will be possible to compute the antenna radiation efficiency for the antenna of the phone under test. If the power feeding the reference antenna is set at the same power as the output power of the phone under test, the efficiency is measured as follows. The difference in the received average power between the reference measurement and the actual measurement for the device under test is a measure of the difference between the antenna efficiencies for the two cases. This difference is used as the antenna radiation efficiency value for the device in question and represents the radiation efficiency of the device in free space.

The final step of the method is to insert the experimental value for the antenna radiation efficiency into the numerically calculated function for the SAR value inside the head to determine the SAR value for the device in question.

The voltage standing wave ratio at the antenna feeding point may be used, if necessary, together with experimental data on how the output power from the Power Amplifier (PA) is affected by the voltage standing wave ratio (VSWR). In this way, the direct interaction between the user and the power output amplifier could be modelled.

The method of determining SAR for a radio communications device of a given type comprises the steps illustrated in figures 13, 14 and 15.

Figure 13 shows a flow chart for the measurement of the Specific Absorption Rate (SAR) of a radio device in a mode-stirred chamber according to the invention.

It comprises the following steps:

Step S0:    Start
Step S1:    Numerical model exists? If yes, go to step S3. If no, go to step S2.
Step S2:    Create numerical model of the radio device type, including a phantom body (e.g. head and hand holding device).
Step S3:    Calculate interaction between radio device and body using numerical model by the finite difference time domain (FDTD) method.
Step S4:    Extract calculated peak Specific Absorption Rate (SAR) value inside the body expressed as a function of 1) the power amplifier power and the 2) the antenna efficiency.

Step S5: Measure average received power of the device under test (DUT) in a mode-stirred chamber without phantom body. The sub-steps of this measurement are detailed in figure 14 and listed below.

Step S6: Reference measurement exists? If yes, go to step S8. If no, go to step S7.

Step S7: Make a reference measurement with antenna of known antenna efficiency in a mode-stirred chamber without phantom body. The sub-steps of this measurement are detailed in figure 15 and listed below.

Step S8: Determine antenna efficiency for the radio device by subtracting the measured values of average received power.

Step S9: Power amplifier (PA) power measurement exists? If yes, go to step S11. If no, go to step S10.

Step S10: Make a measurement of output power of power amplifier (PA) for each individual radio device.

Step S11: Determine Specific Absorption Rate (SAR) value by inserting measured values for antenna efficiency and power amplifier (PA) power of radio device in numerical model.

Step S12: End.

Figure 14 shows a flow chart for the measurement of average received power in a mode-stirred chamber according to the invention. The measurements comprise the following steps, detailing step S5 of fig. 13:

Step S5.1: Power device under test (DUT) by battery.

Step S5.2: Put device under test in transmit mode.

Step S5.3: Set device under test to static transmission at a selected frequency.

Step S5.4: Place device under test in mode-stirred chamber (MSC) with receiving antenna.

Step S5.5: Rotate stirrer one revolution and measure received power from device under test versus angle during the revolution.

Step S5.6: Calculate average received power from device under test.

Figure 15 shows a flow chart for a reference measurement in a mode-stirred chamber according to the invention. The measurements comprise the following steps, detailing step S7 of fig. 13:

Step S7.1: Place reference antenna in mode-stirred chamber (MSC) with same receiving antenna and cable as used for device under test (DUT).

Step S7.2: Feed reference antenna with a known input power equal to the output power of the device under test.

Step S7.3: Rotate stirrer one revolution and measure received power from reference antenna versus angle during the revolution.

Step S7.4: Calculate average received power from reference antenna.

It should be noted that some of the steps in the above procedures may be interchanged and lead to the same end result.

Some preferred embodiments have been shown in the foregoing, but it should be stressed that the invention is not limited to these, but may be embodied in other ways within the subject matter defined in the following claims.

## Claims

1. A method of handling a plurality of electronic devices (414) simultaneously in a mode-stirred chamber (101, 201, 301, 401), the method comprising:

   positioning a plurality of electronic devices (414) within the chamber (101, 201, 301, 401);
   transmitting radio frequency signals directly to the plurality of electronic devices (414) from a transmitting antenna of the chamber (101, 201, 301, 401);
   processing the electronic devices (414) within the chamber (101, 201, 301, 401);
   receiving airbome signals directly from the plurality of electronic devices (414) at a receiver of the chamber (101, 201, 301, 401), the received airborne signals relating to processing results of the plurality of electronic devices (414); and
   removing the plurality of electronic devices (414) from the chamber (101, 201, 301, 401).

2. A method as claimed in claim 1, wherein a mode stirrer (310, 410, 411 ) is rotated within the chamber (101, 201, 301, 401)

3. A method as claimed in claim 1, wherein the step of processing comprises downloading software to the electronic devices (414).

4. A method as claimed in claim 1, wherein the step of processing comprises the step of testing the electronic devices (414).

5. A method as claimed in claim 4, wherein the step of testing comprises testing acoustic properties of the electronic devices (414).

6. A method as claimed in claim 4, wherein the step of testing comprises testing optical properties of the electronic devices (414).

7. A method as claimed in claim 4 wherein the step of testing comprises testing radio properties of the electronic devices (414).

8. A method as claimed in claim 4 wherein the step of testing comprises testing under different climatic conditions.

9. A method as claimed in claim 4, wherein the tests of the devices (414) are performed synchronously.

10. A method as claimed in claim 4, wherein the tests of the devices (414) are performed sequentially.

11. A method as claimed in claim 4, wherein the tests of the devices (414) are different for different devices (414).

12. A method as claimed in claim 4, wherein each device is assigned a unique receive and transmit radio frequency channel.

13. A method as claimed in claim 4, wherein the step of testing comprises testing the average output power of each of the devices (414).

14. A method as claimed in claim 13, wherein testing the output power of each of the devices (414) involves the rotation of a stirrer (310, 410, 411) in the chamber (101, 201, 301, 401) and averaging the results of several measurements for each rotation of the stirrer (310, 410, 411).

15. A method as claimed in claim 4, wherein the step of testing comprises testing the radiation efficiency of each of the devices (414).

16. A method as claimed in claim 15, wherein testing the radiation efficiency of each of the devices (414) involves first making a measurement using a reference antenna of known radiation efficiencyand comparing this efficiency with measurements from the devices (414).

17. A method as claimed in claim 16, wherein the testing comprises determining the specific absorption rate (SAR) of each of the devices (414) by performing the steps of creating a numerical model (S1, S3, S4) of the devices (414) and their interaction with a phantom body, determining (S5, S7, S8) the radiation efficiency of each of the devices (414) in the chamber (101, 201, 301, 401) and calculating the SAR value (S10, S11) for each device (414) using said numerical model and individual values of radiation efficiency.

18. A method as claimed in claim 1, wherein the positioning of the devices (414) entering the chamber (101, 201, 301, 401) further comprises a step of adjusting the distance between adjacent devices (414) in order to optimise the influence of mutual coupling on the processing results.

19. A method as claimed in claim 1, wherein the positioning and removing steps take place through at least one EMC shielding opening element.

20. A method as claimed in claim 1, wherein the positioning and removing steps comprise passing the devices (414) through waveguides with cut-off frequencies above the highest frequency used for test in the chamber.

21. A method as claimed in claim 1, wherein the devices (414) are transported by use of a conveyor consisting of a dielectric support material.

22. A method as claimed in claim 3 and 4, wherein the downloading of software and the testing take place over separate air interfaces.

23. A method as claimed in claim 4 or 22, wherein the devices (414) are tested according to a predetermined test program.

24. A method as claimed in claims 22, wherein the electronic devices (414) comprise separate transmit modules for the separate air interfaces.

25. A method as claimed in claims 22, wherein the electronic devices (414) comprise separate receive modules for the separate air interfaces.

26. A method as claimed in claim 1, wherein the devices (414) are kept in a controlled atmosphere, temperature and humidity, by use of a small inner chamber.

27. A method as claimed in claim 1, wherein the processing is performed at different frequencies.

28. A mode-stirred chamber (101, 201, 301, 401) for handling a plurality of electronic devices (414) simultaneously, comprising:

   means for positioning a plurality of electronic devices (414) in the chamber;
   a transmit antenna (409);
   a base station (420) operable to transmit radio frequency signals directly to electronic devices (414) positioned within the chamber (101, 201, 301, 401) via the transmit antenna (409);
   a receiver for receiving airborne signals directly from the plurality of electronic devices (414), the airborne signals relating to processing results of the electronic devices (414); and
   means for removing the plurality of electronic devices (414) from the chamber.

29. A mode-stirred chamber (101, 201, 301, 401) as claimed in claim 28, further comprising at least one mode stirrer (310, 410, 411).

30. A mode-stirred chamber (101, 201, 301, 401) as claimed in claim 29, wherein the at least one mode-stirrer (310, 410, 411) is covered with a dielectric material with a high dielectric constant and a low loss factor.

31. A mode-stirred chamber (101, 201, 301, 401) as claimed in claim 28, wherein the base station (420) is adapted to download software to electronic devices (414) positioned within the chamber.

32. A mode-stirred chamber (101, 201, 301, 401) as claimed in claim 28, wherein the chamber (101, 201, 301, 401) is adapted to test electronic devices (414) positioned within the chamber.

33. A mode-stirred chamber (101, 201, 301, 401) as claimed in claim 32, wherein the chamber (101, 201, 301, 401) is adapted to test acoustic properties of such electronic devices (414).

34. A mode-stirred chamber (101, 201, 301, 401) as claimed in claim 32, wherein the chamber (101, 201, 301, 401) is adapted to test optical properties of such electronic devices (414).

35. A mode-stirred chamber (101, 201, 301, 401) as claimed in claim 32, wherein the chamber (101, 201, 301, 401) is adapted to test radio properties of such electronic devices (414).

36. A mode-stirred chamber (101, 201, 301, 401) as claimed in claim 32, wherein the chamber (101, 201, 301, 401) is adapted to conduct tests under different climatic conditions.

37. A mode-stirred chamber (101, 201, 301, 401) as claimed in claim 32, wherein the chamber (101, 201, 301, 401) is adapted to test such electronic devices (414) synchronously.

38. A mode-stirred chamber (101, 201, 301, 401) as claimed in claim 32, wherein the chamber (101, 201, 301, 401) is adapted to test such electronic devices (414) sequentially.

**39.** A mode-stirred chamber (101, 201, 301, 401) as claimed in claim 32, wherein the chamber (101, 201, 301, 401) is adapted to perform different tests on different electronic devices (414).

**40.** A mode-stirred chamber (101, 201, 301, 401) as claimed in claim 32, wherein the chamber (101, 201, 301, 401) is adapted to test the average output power of each of such electronic devices (414).

**41.** A mode-stirred chamber (101, 201, 301, 401) as claimed in claim 32, wherein the chamber (101, 201, 301, 401) is adapted to test the radiation efficiency of each of such electronic devices (414).

**42.** A mode-stirred chamber (101, 201, 301, 401) as claimed in claim 28, further comprising a reference antenna.

**43.** A mode-stirred chamber (101, 201, 301, 401) as claimed in claim 28, further comprising at least one EMC shielding opening element (102).

**44.** A mode-stirred chamber (101, 201, 301, 401) as claimed in claim 28, further comprising at least one electromagnetic waveguide (204, 205, 404, 405) for positioning and removing electronic devices (414).

**45.** A mode-stirred chamber (101, 201, 301, 401) as claimed in claim 44, wherein the at least one electromagnetic waveguide has a cut off frequency above the highest frequency used for test in the chamber.

**46.** A mode-stirred chamber (101, 201, 301, 401) as claimed in claim 28, further comprising a conveyor (432) consisting of a dielectric support material for transporting electronic devices (414).

**47.** A mode-stirred chamber (101, 201, 301, 401) as claimed in claim 28, further comprising a separate inner chamber (101, 201, 301, 401) adapted to keep electronic devices (414) in a controlled atmosphere.

**48.** A mode-stirred chamber (101, 201, 301, 401) as claimed in claim 28, wherein the chamber (101, 201, 301, 401) is a climatic chamber.

**49.** A mode-stirred chamber (101, 201, 301, 401) as claimed in claim 28, wherein the chamber (101, 201, 301, 401) is electromagnetically shielded.

**50.** A mode-stirred chamber (101, 201, 301,401) as claimed in claim 28, wherein the chamber (101, 201, 301, 401) is anechoic.

**51.** A mode-stirred chamber (101, 201, 301, 401) as claimed in claim 28, wherein the chamber (101, 201, 301, 401) is echoic.

**52.** A mode-stirred chamber (101, 201, 301, 401) as claimed in claim 28, further comprising at least one field diffusing element.

**53.** A mode-stirred chamber (101, 201, 301, 401) as claimed in claim 52, the at least one field diffusing comprising cavities located inside the chamber (101, 201, 301, 401) filled with dielectric material with a high dielectric constant and a low loss factor.

**54.** A mode-stirred chamber (101, 201, 301, 401) as claimed in claim 28, further comprising a vibrator suitable for inducing mechanical vibrations in such electronic devices (414).

**55.** A mode-stirred chamber (101, 201, 301, 401) as claimed in claim 28, further comprising at least one receiving antenna for each electronic device under test.

**56.** A mode-stirred chamber (101, 201, 301, 401) as claimed in claim 28, further comprising at least one receive antenna (423).

**Patentansprüche**

**1.** Verfahren zum zeitgleichen Bedienen einer Vielzahl elektronischer Vorrichtungen (414) in einer modengerührten Kammer (101, 201, 301, 401), wobei das Verfahren folgende Verfahrensschritte aufweist:

Positionieren einer Vielzahl elektronischer Vorrichtungen (414) innerhalb der Kammer (101, 201, 301, 401);

Übertragen von Funk-Frequenzsignalen direkt zu der Vielzahl der elektronischen Vorrichtungen (414) von einer Übertragungs-Antenne der Kammer (101, 201, 301, 401);

Bearbeiten der elektronischen Vorrichtungen (414) innerhalb der Kammer (101, 201, 301, 401);

Empfangen von luftübertragenen Signalen direkt von der Vielzahl der elektronischen Vorrichtungen (414) bei einem Empfänger der Kammer (101, 201, 301, 401), wobei die empfangenen luftübertragenen Signale mit Bearbeitungsergebnissen der Vielzahl der elektronischen Vorrichtungen (414) in Beziehung stehen; und

Entfernen der Vielzahl der elektronischen Vorrichtungen (414) aus der Kammer (101, 201, 301, 401).

2. Verfahren nach Anspruch 1, in welchem innerhalb der Kammer (101, 201, 301, 401) ein Moden-Rührer (310, 410, 411) gedreht wird.

3. Verfahren nach Anspruch 1, in welchem der Verfahrensschritt des Bearbeitens den Verfahrensschritt des Herunterladens von Software auf die elektronischen Vorrichtungen (414) aufweist.

4. Verfahren nach Anspruch 1, in welchem der Verfahrensschritt des Bearbeitens den Verfahrensschritt des Prüfens der elektronischen Vorrichtungen (414) aufweist.

5. Verfahren nach Anspruch 4, in welchem der Verfahrensschritt des Prüfens den Verfahrensschritt des Prüfens von akustischen Eigenschaften der elektronischen Vorrichtungen (414) aufweist.

6. Verfahren nach Anspruch 4, in welchem der Verfahrensschritt des Prüfens den Verfahrensschritt des Prüfens optischer Eigenschaften der elektronischen Vorrichtungen (414) aufweist.

7. Verfahren nach Anspruch 4, in welchem der Verfahrensschritt des Prüfens den Verfahrensschritt des Prüfens von Funk-Eigenschaften der elektronischen Vorrichtungen (414) aufweist.

8. Verfahren nach Anspruch 4, in welchem der Verfahrensschritt des Prüfens den Verfahrensschritt des Prüfens bei verschiedenen klimatischen Bedingungen aufweist.

9. Verfahren nach Anspruch 4, in welchem die Prüfungen der Vorrichtungen (414) zeitgleich ausgeführt werden.

10. Verfahren nach Anspruch 4, in welchem die Prüfungen der Vorrichtungen (414) sequentiell ausgeführt werden.

11. Verfahren nach Anspruch 4, in welchem die Prüfungen der Vorrichtungen (414) für verschiedene Vorrichtungen (414) unterschiedlich sind.

12. Verfahren nach Anspruch 4, in welchem jede Vorrichtung einem eindeutigen Empfangs- und Übertragungs-Funk-Frequenzkanal zugeordnet ist.

13. Verfahren nach Anspruch 4, in welchem der Verfahrensschritt des Prüfens den Verfahrensschritt des Prüfens der mittleren Ausgabeleistung von jeder der Vorrichtungen (414) aufweist.

14. Verfahren nach Anspruch 13, in welchem das Prüfen der Ausgabeleistung von jeder der Vorrichtungen (414) das Drehen eines Rührers (310, 410, 411) in der Kammer (101, 201, 301, 401) nach sich zieht, und in welchem die Ergebnisse von verschiedenen Messungen für jede Umdrehung des Rührers (310, 410, 411) ermittelt werden.

15. Verfahren nach Anspruch 4, in welchem der Verfahrensschritt des Prüfens den Verfahrensschritt des Prüfens der Strahlungseffizienz von jeder der Vorrichtungen (414) aufweist.

16. Verfahren nach Anspruch 15, in welchem das Prüfen der Strahlungseffizienz von jeder der Vorrichtungen (414) zunächst das Durchführen einer Messung unter Verwendung einer Referenz-Antenne mit bekannter Strahlungs-Effizienz und das Vergleichen dieser Effizienz mit Messungen von den Vorrichtungen (414) nach sich zieht.

**17.** Verfahren nach Anspruch 16, in welchem das Prüfen das Ermitteln der spezifischen Absorptionsrate (SAR) von jeder der Vorrichtungen (414) aufweist, und zwar indem die Verfahrensschritte des Erzeugens eines numerischen Modells (S1, S3, S4) der Vorrichtungen (414) und deren Interaktion mit einem Phantom-Körper, das Ermitteln (S5, S7, S8) der Strahlungs-Effizienz von jeder der Vorrichtungen (414) in der Kammer (101, 201, 301, 401) sowie das Berechnen des SAR-Wertes (S10, S11) für jede Vorrichtung (414) unter Verwendung des numerischen Modells sowie individueller Werte der Strahlungs-Effizienz durchgeführt werden.

**18.** Verfahren nach Anspruch 1, in welchem der Verfahrensschritt des Positionierens der Vorrichtungen (414), die in die Kammer (101, 201, 301, 401) eingeführt werden, ferner einen Verfahrensschritt des Einstellens der Entfernung zwischen angrenzenden Vorrichtungen (414) aufweist, um den Einfluss der gegenseitigen Kopplung auf die Bearbeitungsergebnisse zu optimieren.

**19.** Verfahren nach Anspruch 1, in welchem die Verfahrensschritte des Positionierens und des Entfernens durch zumindest ein EMC-Abschirm-Öffnungselement hindurch ablaufen.

**20.** Verfahren nach Anspruch 1, in welchem die Verfahrensschritte des Positionierens und des Entfernens den Verfahrensschritt des Übergebens bzw. Übertragens der Vorrichtungen (414) durch Wellenleiter mit Cut-Off-Frequenzen über der für Prüfungen in der Kammer verwendeten höchsten Frequenz aufweisen.

**21.** Verfahren nach Anspruch 1, in welchem die Vorrichtungen (414) unter Verwendung eines Beförderungsmittels, das aus einem dielektrischen Auflagematerial besteht, transportiert werden.

**22.** Verfahren nach Anspruch 3 und 4, in welchem der Verfahrensschritt des Herunterladens von Software und der Verfahrensschritt der Prüfung über getrennte Luft-Schnittstellen ablaufen.

**23.** Verfahren nach Anspruch 4 oder 22, in welchem die Vorrichtungen (414) gemäß einem festgelegten Testprogramm geprüft werden.

**24.** Verfahren nach Anspruch 22, in welchem die elektronischen Vorrichtungen (414) separate Übertragungs-Module für die getrennten Luft-Schnittstellen aufweisen.

**25.** Verfahren nach Anspruch 22, in welchem die elektronischen Vorrichtungen (414) für die getrennten Luft-Schnittstellen separate Empfangs-Module aufweisen.

**26.** Verfahren nach Anspruch 1, in welchem die Vorrichtungen (414) unter Verwendung einer kleinen Innen-Kammer in einer kontrollierten Atmosphäre, Temperatur und Luftfeuchtigkeit gehalten werden.

**27.** Verfahren nach Anspruch 1, in welchem der Verfahrensschritt des Bearbeitens bei verschiedenen Frequenzen durchgeführt wird.

**28.** Moden-gerührte Kammer (101, 201, 301, 401) zum zeitgleichen Bedienen einer Vielzahl elektronischer Vorrichtungen (414), wobei die Kammer folgendes aufweist:

eine Einrichtung zum Positionieren einer Vielzahl elektronischer Vorrichtungen (414) in der Kammer;

eine Übertragungs-Antenne (409);

eine Basisstation (420), die ausgelegt ist, Funk-Frequenzsignale über die Übertragungs-Antenne (409) direkt zu innerhalb der Kammer (101, 201, 301, 401) positionierten elektronischen Vorrichtungen (414) zu übertragen;

einen Empfänger zum Empfangen von luftübertragenen Signalen direkt von der Vielzahl der elektronischen Vorrichtungen (414), wobei sich die luftübertragenen Signale auf Bearbeitungsergebnisse der elektronischen Vorrichtungen (414) beziehen; und

eine Einrichtung zum Entfernen der Vielzahl der elektronischen Vorrichtungen (414) aus der Kammer.

**29.** Moden-gerührte Kammer (101, 201, 301, 401) nach Anspruch 28, welche ferner zumindest einen Moden-Rührer (310, 410, 411) aufweist.

**30.** Moden-gerührte Kammer (101, 201, 301, 401) nach Anspruch 29, in welcher der zumindest eine Moden-Rührer (310, 410, 411) mit einem dielektrischen Material mit einer hohen dielektrischen Konstante und einem niedrigen Verlustfaktor bedeckt ist.

**31.** Moden-gerührte Kammer (101, 201, 301, 401) nach Anspruch 28, in welcher die Basisstation (420) ausgelegt ist, Software auf innerhalb der Kammer positionierte elektronische Vorrichtungen (414) herunterzuladen.

**32.** Moden-gerührte Kammer (101, 201, 301, 401) nach Anspruch 28, in welcher die Kammer (101, 201, 301, 401) ausgelegt ist, innerhalb der Kammer positionierte elektronische Vorrichtungen (414) zu prüfen.

**33.** Moden-gerührte Kammer (101, 201, 301, 401) nach Anspruch 32, in welcher die Kammer (101, 201, 301, 401) ausgelegt ist, akustische Eigenschaften von solchen elektronischen Vorrichtungen (414) zu prüfen.

**34.** Moden-gerührte Kammer (101, 201, 301, 401) nach Anspruch 32, in welcher die Kammer (101, 201, 301, 401) ausgelegt ist, optische Eigenschaften von solchen elektronischen Vorrichtungen (414) zu prüfen.

**35.** Moden-gerührte Kammer (101, 201, 301, 401) nach Anspruch 32, in welcher die Kammer (101, 201, 301, 401) ausgelegt ist, Funk-Eigenschaften von solchen elektronischen Vorrichtungen (414) zu prüfen.

**36.** Moden-gerührte Kammer (101, 201, 301, 401) nach Anspruch 32, in welcher die Kammer (101, 201, 301, 401) ausgelegt ist, unter verschiedenen klimatischen Bedingungen Prüfungen durchzuführen.

**37.** Moden-gerührte Kammer (101, 201, 301, 401) nach Anspruch 32, in welcher die Kammer (101, 201, 301, 401) ausgelegt ist, zeitgleich solche elektronischen Vorrichtungen (414) zu prüfen.

**38.** Moden-gerührte Kammer (101, 201, 301, 401) nach Anspruch 32, in welcher die Kammer (101, 201, 301, 401) ausgelegt ist, sequentiell solche elektronischen Vorrichtungen (414) zu prüfen.

**39.** Moden-gerührte Kammer (101, 201, 301, 401) nach Anspruch 32, in welcher die Kammer (101, 201, 301, 401) ausgelegt ist, verschiedene Prüfungen an unterschiedlichen elektronischen Vorrichtungen (414) auszuführen.

**40.** Moden-gerührte Kammer (101, 201, 301, 401) nach Anspruch 32, in welcher die Kammer (101, 201, 301, 401) ausgelegt ist, die mittlere Ausgabeleistung von jeder Vorrichtung von solchen elektronischen Vorrichtungen (414) zu prüfen.

**41.** Moden-gerührte Kammer (101, 201, 301, 401) nach Anspruch 32, in welcher die Kammer (101, 201, 301, 401) ausgelegt ist, die Strahlungs-Effizienz von jeder Vorrichtung von solchen elektronischen Vorrichtungen (414) zu prüfen.

**42.** Moden-gerührte Kammer (101, 201, 301, 401) nach Anspruch 28, welche ferner eine Referenz-Antenne aufweist.

**43.** Moden-gerührte Kammer (101, 201, 301, 401) nach Anspruch 28, welche ferner zumindest ein EMC-Abschirm-Öffnungselement (102) aufweist.

**44.** Moden-gerührte Kammer (101, 201, 301, 401) nach Anspruch 28, welche ferner zumindest einen elektromagnetischen Wellenleiter (204, 205, 404, 405) zum Positionieren und zum Entfernen elektronischer Vorrichtungen (414) aufweist.

**45.** Moden-gerührte Kammer (101, 201, 301, 401) nach Anspruch 44, in welcher der zumindest eine elektromagnetische Wellenleiter eine Cut-Off-Frequenz über der für Prüfungen in der Kammer verwendeten höchsten Frequenz aufweist.

**46.** Moden-gerührte Kammer (101, 201, 301, 401) nach Anspruch 28, die zum Transportieren elektronischer Vorrichtungen (414) ferner ein Beförderungsmittel (432) aufweist, welches aus einem dielektrischen Trägermaterial besteht.

**47.** Moden-gerührte Kammer (101, 201, 301, 401) nach Anspruch 28, welche ferner eine separate Innen-Kammer (101, 201, 301, 401) aufweist, die ausgelegt ist, elektronische Vorrichtungen (414) in einer kontrollierten Atmosphäre zu halten.

**48.** Moden-gerührte Kammer (101, 201, 301, 401) nach Anspruch 28, in welcher die Kammer (101, 201, 301, 401) eine Klima-Kammer ist.

**49.** Moden-gerührte Kammer (101, 201, 301, 401) nach Anspruch 28, in welcher die Kammer (101, 201, 301, 401) elektromagnetisch abgeschirmt ist.

**50.** Moden-gerührte Kammer (101, 201, 301, 401) nach Anspruch 28, in welcher die Kammer (101, 201, 301, 401) schalltot ist.

**51.** Moden-gerührte Kammer (101, 201, 301, 401) nach Anspruch 28, in welcher die Kammer (101, 201, 301, 401) eine Echo-Kammer ist.

**52.** Moden-gerührte Kammer (101, 201, 301, 401) nach Anspruch 28, welche ferner zumindest ein Feld-Streuelement aufweist.

**53.** Moden-gerührte Kammer (101, 201, 301, 401) nach Anspruch 52, wobei das zumindest eine Feld-Streuelement innerhalb der Kammer (101, 201, 301, 401) angeordnete Aushöhlungen aufweist, welche mit dielektrischen Material mit einer hohen dielektrischen Konstante und einem geringen Verlustfaktor gefüllt sind.

**54.** Moden-gerührte Kammer (101, 201, 301, 401) nach Anspruch 28, welche ferner eine Schwing-Vorrichtung aufweist, die geeignet ist, mechanische Schwingungen in solche elektronischen Vorrichtungen (414) einzuführen.

**55.** Moden-gerührte Kammer (101, 201, 301, 401) nach Anspruch 28, welche ferner zumindest eine Empfangs-Antenne für jede sich unter Prüfung befindliche elektronische Vorrichtung aufweist.

**56.** Moden-gerührte Kammer (101, 201, 301, 401) nach Anspruch 28, welche ferner zumindest eine Empfangs-Antenne (423) aufweist.

**Revendications**

**1.** Procédé pour travailler simultanément sur une multiplicité de dispositifs électroniques (414) dans une chambre à brassage de modes (101, 201, 301, 401), le procédé comprenant les étapes suivantes :

on positionne une multiplicité de dispositifs électroniques (414) à l'intérieur de la chambre (101, 201, 301, 401);
on émet des signaux radiofréquence directement vers la multiplicité de dispositifs électroniques (414) à partir d'une antenne émettrice de la chambre (101, 201, 301, 401);
on traite les dispositifs électroniques (414) à l'intérieur de la chambre (101, 201, 301, 401);
on reçoit à un récepteur de la chambre (101, 201, 301, 401) des signaux se propageant dans l'air directement à partir de la multiplicité de dispositifs électroniques (414), les signaux se propageant dans l'air qui sont reçus concernant des résultats de traitement de la multiplicité de dispositifs électroniques (414); et
on retire de la chambre (101, 201, 301, 401) la multiplicité de dispositifs électroniques (414).

**2.** Procédé selon la revendication 1, dans lequel on fait tourner un brasseur de modes (310, 410, 411) à l'intérieur de la chambre (101, 201, 301, 401).

**3.** Procédé selon la revendication 1, dans lequel l'étape de traitement comprend l'opération consistant à télécharger du logiciel vers les dispositifs électroniques (414).

**4.** Procédé selon la revendication 1, dans lequel l'étape de traitement comprend l'étape consistant à tester les dispositifs électroniques (414).

**5.** Procédé selon la revendication 4, dans lequel l'étape de test comprend le test de propriétés acoustiques des dispositifs électroniques (414).

**6.** Procédé selon la revendication 4, dans lequel l'étape de test comprend le test de propriétés optiques des dispositifs électroniques (414).

**7.** Procédé selon la revendication 4, dans lequel l'étape de test comprend le test de propriétés radioélectriques des dispositifs électroniques (414).

**8.** Procédé selon la revendication 4, dans lequel l'étape de test comprend l'accomplissement de tests sous différentes conditions climatiques.

**9.** Procédé selon la revendication 4, dans lequel les tests des dispositifs (414) sont effectués en synchronisme.

**10.** Procédé selon la revendication 4, dans lequel les tests des dispositifs (414) sont effectués séquentiellement.

**11.** Procédé selon la revendication 4, dans lequel les tests des dispositifs (414) sont différents pour différents dispositifs (414).

**12.** Procédé selon la revendication 4, dans lequel un canal radiofréquence de réception et d'émission particulier est assigné à chaque dispositif.

**13.** Procédé selon la revendication 4, dans lequel l'étape de test comprend le test de la puissance de sortie moyenne de chacun des dispositifs (414).

**14.** Procédé selon la revendication 13, dans lequel le test de la puissance de sortie de chacun des dispositifs (414) fait intervenir la rotation d'un brasseur (310, 410, 411) dans la chambre (101, 201, 301, 401) et le calcul de la moyenne des résultats de plusieurs mesures pour chaque révolution du brasseur (310, 410, 411).

**15.** Procédé selon la revendication 4, dans lequel l'étape de test comprend le test du rendement de rayonnement de chacun des dispositifs (414).

**16.** Procédé selon la revendication 15, dans lequel le test du rendement de rayonnement de chacun des dispositifs (414) fait intervenir premièrement l'accomplissement d'une mesure en utilisant une antenne de référence de rendement de rayonnement connu, et la comparaison de ce rendement avec des mesures faites sur les dispositifs (414).

**17.** Procédé selon la revendication 16, dans lequel le test comprend la détermination du taux d'absorption spécifique (SAR pour "Specific Absorption Rate") de chacun des dispositifs (414) en accomplissant les étapes de création d'un modèle numérique (S1, S3, S4) des dispositifs (414) et de leur interaction avec un corps fantôme, de détermination (S5, S7, S8) du rendement de rayonnement de chacun des dispositifs (414) dans la chambre (101, 201, 301, 401), et de calcul de la valeur de SAR (S10, S11) pour chaque dispositif (414) en utilisant ledit modèle numérique et des valeurs individuelles de rendement de rayonnement.

**18.** Procédé selon la revendication 1, dans lequel le positionnement des dispositifs (414) entrant dans la chambre (101, 201, 301, 401) comprend en outre une étape de réglage de la distance entre des dispositifs (414) adjacents afin d'optimiser l'influence du couplage mutuel sur les résultats de traitement.

**19.** Procédé selon la revendication 1, dans lequel les étapes de positionnement et de retrait sont accomplies à travers au moins un élément d'ouverture procurant un blindage de CEM.

**20.** Procédé selon la revendication 11, dans lequel les étapes de positionnement et de retrait comprennent le passage des dispositifs (414) à travers des guides d'ondes ayant des fréquences de coupure supérieures à la fréquence la plus élevée utilisée pour des tests dans la chambre.

**21.** Procédé selon la revendication 1, dans lequel les dispositifs (414) sont transportés par l'utilisation d'un convoyeur consistant en un matériau de support diélectrique.

**22.** Procédé selon la revendication 3 ou 4, dans lequel le téléchargement de logiciel et le test ont lieu par des interfaces radio séparées.

**23.** Procédé selon la revendication 4 ou 22, dans lequel les dispositifs (414) sont testés conformément à un programme de test prédéterminé.

**24.** Procédé selon la revendication 22, dans lequel les dispositifs électroniques (414) comprennent des modules d'émission séparés pour les interfaces radio séparées.

**25.** Procédé selon la revendication 22, dans lequel les dispositifs électroniques (414) comprennent des modules de réception séparés pour les interfaces radio séparées.

**26.** Procédé selon la revendication 1, dans lequel les dispositifs (414) sont maintenus dans une atmosphère commandée, en ce qui concerne la température et l'humidité, par l'utilisation d'une petite chambre intérieure.

**27.** Procédé selon la revendication 1, dans lequel le traitement est effectué à différentes fréquences.

**28.** Chambre à brassage de modes (101, 201, 301, 401) pour travailler simultanément sur une multiplicité de dispositifs électroniques (414), comprenant :

un moyen pour positionner une multiplicité de dispositifs électroniques (414) dans la chambre;
une antenne d'émission (409);
une station de base (420) pouvant fonctionner de façon à émettre des signaux radiofréquence directement vers des dispositifs électroniques (414) positionnés à l'intérieur de la chambre (101, 201, 301, 401), par l'intermédiaire de l'antenne d'émission (409);
un récepteur pour recevoir des signaux se propageant dans l'air, provenant directement de la multiplicité de dispositifs électroniques (414), les signaux se propageant dans l'air concernant des résultats de traitement des dispositifs électroniques (414); et
un moyen pour retirer de la chambre la multiplicité de dispositifs électroniques (414).

**29.** Chambre à brassage de modes (101, 201, 301, 401) selon la revendication 28, comprenant en outre au moins un brasseur de modes (310, 410, 411).

**30.** Chambre à brassage de modes (101, 201, 301, 401) selon la revendication 29, dans laquelle l'au moins un brasseur de modes (310, 410, 411) est couvert avec un matériau diélectrique ayant une constante diélectrique élevée et un faible facteur de pertes.

**31.** Chambre à brassage de modes (101, 201, 301, 401) selon la revendication 28, dans laquelle la station de base (420) est adaptée pour télécharger du logiciel vers des dispositifs électroniques (414) positionnés à l'intérieur de la chambre.

**32.** Chambre à brassage de modes (101, 201, 301, 401) selon la revendication 28, dans laquelle la chambre (101, 201, 301, 401) est adaptée pour tester des dispositifs électroniques (414) positionnés à l'intérieur de la chambre.

**33.** Chambre à brassage de modes (101, 201, 301, 401) selon la revendication 32, dans laquelle la chambre (101, 201, 301, 401) est adaptée pour tester des propriétés acoustiques de tels dispositifs électroniques (414).

**34.** Chambre à brassage de modes (101, 201, 301, 401) selon la revendication 32, dans laquelle la chambre (101, 201, 301, 401) est adaptée pour tester des propriétés optiques de tels dispositifs électroniques (414).

**35.** Chambre à brassage de modes (101, 201, 301, 401) selon la revendication 32, dans laquelle la chambre (101, 201, 301, 401) est adaptée pour tester des propriétés radioélectriques de tels dispositifs électroniques (414).

**36.** Chambre à brassage de modes (101, 201, 301, 401) selon la revendication 32, dans laquelle la chambre (101, 201, 301, 401) est adaptée pour effectuer des tests sous différentes conditions climatiques.

**37.** Chambre à brassage de modes (101, 201, 301, 401) selon la revendication 32, dans laquelle la chambre (101, 201, 301, 401) est adaptée pour tester de tels dispositifs électroniques (414) en synchronisme.

**38.** Chambre à brassage de modes (101, 201, 301, 401) selon la revendication 32, dans laquelle la chambre (101, 201, 301, 401) est adaptée pour tester séquentiellement de tels dispositifs électroniques (414).

**39.** Chambre à brassage de modes (101, 201, 301, 401) selon la revendication 32, dans laquelle la chambre (101, 201, 301, 401) est adaptée pour effectuer des tests différents sur différents dispositifs électroniques (414).

**40.** Chambre à brassage de modes (101, 201, 301, 401) selon la revendication 32, dans laquelle la chambre (101, 201, 301, 401) est adaptée pour tester la puissance de sortie moyenne de chacun de tels dispositifs électroniques (414).

**41.** Chambre à brassage de modes (101, 201, 301, 401) selon la revendication 32, dans laquelle la chambre (101, 201, 301, 401) est adaptée pour tester le rendement de rayonnement de chacun de tels dispositifs électroniques (414).

**42.** Chambre à brassage de modes (101, 201, 301, 401) selon la revendication 28, comprenant en outre une antenne de référence.

**43.** Chambre à brassage de modes (101, 201, 301, 401) selon la revendication 28, comprenant en outre au moins un élément d'ouverture (102) constituant un blindage de CEM.

**44.** Chambre à brassage de modes (101, 201, 301, 401) selon la revendication 28, comprenant en outre au moins un guide d'ondes électromagnétique (204, 205, 404, 405) pour positionner et retirer des dispositifs électroniques (414).

**45.** Chambre à brassage de modes (101, 201, 301, 401) selon la revendication 44, dans laquelle l'au moins un guide d'ondes électromagnétique a une fréquence de coupure supérieure à la fréquence la plus élevée utilisée pour des tests dans la chambre.

**46.** Chambre à brassage de modes (101, 201, 301, 401) selon la revendication 28, comprenant en outre un convoyeur (432) consistant en un matériau de support diélectrique pour transporter des dispositifs électroniques (414).

**47.** Chambre à brassage de modes (101, 201, 301, 401) selon la revendication 28, comprenant en outre une chambre intérieure séparée (101, 201, 301, 401) adaptée pour maintenir des dispositifs électroniques (414) dans une atmosphère commandée.

**48.** Chambre à brassage de modes (101, 201, 301, 401) selon la revendication 28, dans laquelle la chambre (101, 201, 301, 401) est une chambre climatique.

**49.** Chambre à brassage de modes (101, 201, 301, 401) selon la revendication 28, dans laquelle la chambre (101, 201, 301, 401) est blindée au point de vue électromagnétique.

**50.** Chambre à brassage de modes (101, 201, 301, 401) selon la revendication 28, dans laquelle la chambre (101, 201, 301, 401) est anéchoïque.

**51.** Chambre à brassage de modes (101, 201, 301, 401) selon la revendication 28, dans laquelle la chambre (101, 201, 301, 401) est réverbérante.

**52.** Chambre à brassage de modes (101, 201, 301, 401) selon la revendication 28, comprenant en outre au moins un élément de diffusion de champ.

**53.** Chambre à brassage de modes (101, 201, 301, 401) selon la revendication 52, dans laquelle l'au moins un élément de diffusion de champ comprend des cavités placées à l'intérieur de la chambre (101, 201, 301, 401), remplies d'un matériau diélectrique avec une constante diélectrique élevée et un faible facteur de pertes.

**54.** Chambre à brassage de modes (101, 201, 301, 401) selon la revendication 28, comprenant en outre un vibrateur convenant pour induire des vibrations mécaniques dans de tels dispositifs électroniques (414).

**55.** Chambre à brassage de modes (101, 201, 301, 401) selon la revendication 28, comprenant en outre au moins une antenne de réception pour chaque dispositif électronique sous test.

**56.** Chambre à brassage de modes (101, 201, 301, 401) selon la revendication 28, comprenant en outre au moins une antenne de réception (423).

101

102 — 103

**Fig. 1**

201

206   204   205   207

**Fig. 2**

Fig. 3

Fig. 4

**CDF of Chisquare / 2 DOF**

CDF

1.2
1
0.8
0.6
0.4
0.2
0

-40    -30    -20    -10    0    10

Received power referenced to mean (dB)

Fig. 5

**PDF of Chisquare / 2 DOF**

PDF

0.1
0.08
0.06
0.04
0.02
0

-40    -30    -20    -10    0    10

Received power referenced to mean (dB)

Fig. 6

**Cumultative distribution of maximum to mean of chisquare distribution of received power in a mode stirred chamber**

Fig. 7

**Received power vs stirrer postion (hi1)**

Fig. 8

**Power referenced to mean**

Fig. 9

**MSC measured data versus chisquare**

Fig. 10

## Correlation coefficient vs offset

Fig. 11

## CDF of max to mean of Chisquare versus no of independent samples of stirrer positions

Fig. 12

Fig. 13

From S4 in fig. 13

S5.1: Power DUT by battery

S5.2: Put DUT in transmit mode

S5.3: Set DUT to static transmission at a selected frequency

S5.4: Place DUT in MSC with receiving antenna

S5.5: Rotate stirrer one revolution and measure received power from DUT versus angle during the revolution

S5.6: Calculate average received power from DUT

To S6 in fig. 13

# Fig. 14

From S6 in fig. 13

S7.1: Place reference antenna in MSC with same receiving antenna and cable as used for DUT

S7.2: Feed reference antenna with a known input power equal to the output power of the DUT

S7.3: Rotate stirrer one revolution and measure received power from reference antenna versus angle during the revolution

S7.4: Calculate average received power from reference antenna

To S8 in fig. 13

# Fig. 15

Start

Insert energized devices to be tested in MSC

Activate Bluetooth interface for devices

Devices contain basic software?

Download basic software from PC to devices via Bluetooth interface ←No

Yes

Download test program from PC to devices via Bluetooth interface

Set up call to each DUT via base station using different channels

Set environmental conditions

Perform radio test

Perform optical test

Perform acoustic test

No

Transfer test results from devices to PC via Bluetooth channel

Environmental test finished?

Yes

Exit devices from MSC

End

Fig. 16